(19) Europäisches Patentamt
European Patent Office
Office européen des brevets

(11) **EP 2 302 422 A1**

(12) **EUROPEAN PATENT APPLICATION**
published in accordance with Art. 153(4) EPC

(43) Date of publication:
**30.03.2011 Bulletin 2011/13**

(51) Int Cl.:
**G02B 5/02** (2006.01)  **G02B 1/10** (2006.01)
**G02B 1/11** (2006.01)  **G09F 9/00** (2006.01)
**H05K 9/00** (2006.01)

(21) Application number: **09797827.4**

(22) Date of filing: **03.07.2009**

(86) International application number:
**PCT/JP2009/062180**

(87) International publication number:
**WO 2010/007900 (21.01.2010 Gazette 2010/03)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **17.07.2008 JP 2008185688**

(71) Applicant: **Toray Advanced Film Co., Ltd.**
**Chuo-ku**
**Tokyo 103-0021 (JP)**

(72) Inventors:
• **TSUCHIMOTO, Tatsuro**
**Otsu-shi**
**Shiga 520-8558 (JP)**
• **KAI, Nobuyasu**
**Otsu-shi**
**Shiga 520-8558 (JP)**
• **KIRIMOTO, Takayoshi**
**Otsu-shi**
**Shiga 520-8558 (JP)**

(74) Representative: **Kador & Partner**
**Corneliusstrasse 15**
**80469 München (DE)**

(54) **FILTER FOR DISPLAY**

(57) Provided is a filter for a display, which is composed of a laminated body wherein a resin layer is laminated on a conductive layer so as to reduce cost, and has sufficient reflection preventing characteristics and luster. The filter for a display has: the conductive layer composed of a conductive mesh; the resin layer wherein at least a hard coat layer and a reflection preventing layer are laminated in this order on the conductive layer; a recessed structure of the resin layer at a portion where the conductive mesh does not exist; and a protruding structure of the resin layer at a portion where the conductive mesh exists. The resin occupancy R of the protruding structure is 5% or more but less than 20%.

Fig. 5

EP 2 302 422 A1

**Description**

TECHNICAL FIELD

The present invention relates to a filter for a display to be attached to a screen of a display device such as a CRT, an organic EL display, a liquid crystal display and a plasma display, and more specifically concerns a filter for a plasma display that is superior in reflection preventing characteristics and luster.

BACKGROUND ART

Performances required for the display have become more and more strict year after year, and higher demands have been given to a filter for a display that is disposed on the surface of a display so as to improve characteristics of the display. In order to improve the image quality characteristics in an on-state of a display, the following factors are required: to improve the definition of images (definition of transmitted image), to provide high contrast, to reduce reflection image of fluorescent lamps or the like onto the display surface, and to improve the surface quality (to suppress various defects); in contrast, in order to improve the appearance of a display in an off-state, the following factors are required: to improve luster of the display surface, and to properly adjust reflection colors. Among these, the demand for reducing reflection image is very strong, and this can be generally achieved by forming a light diffusion layer having recessed/ protruding structures on a transparent base member. The formation of these recessed/protruding structures can be achieved by applying a transparent paint containing fine particles to the surface so that fine recessed structures are formed on the surface (Patent Documents 1 and 2).
Moreover, together with demands for lowprices of displays, the prices of filters have also become lower year by year, and the demands for cutting costs have become more and more strict. For example, in the case of a plasma display, a general filter structure is formed by laminating a plurality of optical functional films having functions, such as a reflection preventing function, a color-tone correcting function, a near infrared-ray blocking function and an electromagnetic wave blocking function,with adhesivelayersbeinginterposed between them, and with respect to this filter composed of a plurality of films, an attempt has been made to cut costs by forming a filter using only one sheet of a plastic film. For example, a filter in which a reflection preventing layer is formed on one of surfaces of a plastic film, with a conductive layer being formed on the other surface, or a filter in which a conductive film is formed on a plastic film, with a filter on which a reflection preventing layer and a functional resin layer have been stacked being further placed, has been proposed (see Patent Documents 3, 4, 5, 6, and 7).

PRIOR-ART DOCUMENTS

Patent Documents

Patent Document 1:     JP-A No. 2005-316450
Patent Document 2:     JP-A No. 2006-195305
Patent Document 3:     JP-A No. 2007-96049
Patent Document 4:     JP-A No. 2006-54377
Patent Document 5:     JP-A No. 2006-210572
Patent Document 6:     JP-A No. 2007-140282
Patent Document 7:     JP-A No. 2007-243158

DISCLOSURE OF INVENTION

TECHNICAL PROBLEMS TO BE SOLVED

In the techniques of Patent Documents 1 and 2, however, although a superior reflection preventing characteristics can be obtained, a plurality of films are required for a filter for a display, with the result that they are insufficient in advantages from the viewpoint of costs. In the techniques of Patent Documents 3 and 4, although the structure is improved from the viewpoint of costs because the filter for a display is formed by using a single film, the reflection preventing characteristics are insufficient since recessed/protruding portions for use in scattering light are not formed on the outermost surface on the visible side. Patent Document 5 has disclosed an electromagnetic-wave shielding member in which a conductive mesh is coated with a curable coat film, with a raised portion of the curable coat film having an average tilt angle of 10° or less . However, in any of the raisedportions exemplified in Examples of Patent Document 5, a resin layer occupancy R, which is defined by the present invention, becomes 20% or more, failing to satisfy sufficient luster. Moreover, in Patent Documents 6 and 7, although the reflection preventing characteristics are improved because of a recessed structure formed on the outermost surface on the visible side, examinations relating to the surface shape have not been sufficiently made, with the result that it is not possible to satisfy both of the reflection preventing characteristics and luster.

Therefore, in view of the above-mentioned conventional technical problems, the object of the present invention is to provide a filter for a display that has sufficient reflection preventing characteristics, and is superior in luster at low costs.

MEANS TO SOLVE THE PROBLEMS

In order to solve the above-mentioned problems, a filter for a display in accordance with the present invention has the following structures:

(1) A filter for a display is provided with: a conductive layer made of a conductive mesh formed on a transparent base member; a resin layer formed on the conductive layer, which has at least a hard coat layer and a reflection preventing layer formed thereon, with the conductive layer, the hard coat layer and the reflection preventing layer being stacked thereon in this order, and in this structure, there is a recess (opening section) on the resin layer at a portion where no conductive mesh exists, with a resin layer occupancy R, defined below, being set in a range from 5% or more but less than 20%:

$$R = (\beta/\alpha) \times 100$$

$\alpha$: area of triangle ABC
$\beta$: area of resin layer located within triangle ABC where with respect to the respective apexes A,B and C of the triangle ABC, when viewed the cross section of the resin layer in a direction orthogonal to the transparent base member so as to pass through two centers of gravity (G1, G2) of adjacent opening sections, surrounded by the conductive mesh, in a surface direction of the transparent base member, a top of the resin layer on the conductive mesh located between the centers of gravity G1 and G2 is defined as C, an intersection between a perpendicular (perpendicular relative to the transparent base member) passing through one of the two centers of gravity G1 and the surface of the resin layer is defined as A, and an intersection between a perpendicular (perpendicular relative to the transparent base member) passing through the other center of gravity G2 and the surface of the resin layer is defined as B.

(2) The filter for a display described in (1), wherein the depth D of the recess of the resin layer is in a range from 0.1 to 5 $\mu$m.
(3) The filter for a display described in (1) or (2), wherein the conductive mesh has a thickness in a range from 0.5 to 8 $\mu$m, and the conductive mesh also has a pitch in a range from 50 to 500 $\mu$m.
(4) The filter for a display described in any one of (1) to (3), which is further provided with a functional layer having at least one function selected from the group consisting of a near infrared-ray blocking function, a color-tone correcting function, an ultraviolet-ray blocking function and a Ne-cutting function.

EFFECTS OF THE INVENTION

In accordance with the present invention, it is possible to provide a filter for display that has sufficient reflection preventing characteristics and is superior in luster at low costs.

BRIEF DESCRIPTION OF DRAWINGS

Fig. 1 is a schematic cross-sectional view showing one example of a resin layer having small flat portions.
Fig. 2 is a schematic cross-sectional view showing one example of a recessed structure of the resin layer of the present invention.
Fig. 3 is a schematic cross-sectional view showing one example of a filter for a display of the present invention, which corresponds to an explanatory drawing that shows a resin layer occupancy R.
Fig. 4 is a schematic drawing showing one example of an opening unit of a conductive mesh.

Fig. 5 is a schematic cross-sectional view that explains a recessed structure of the resin layer of the present invention.

BEST MODE FOR CARRYING OUT THE INVENTION

A filter for a display in accordance with the present invention, which has a conductive layer composed of a conductive mesh formed on a transparent base member, and a resin layer including at least a hard coat layer and a reflection preventing layer formed on the conductive layer, with the conductive layer, the hard coat layer and the reflection preventing layer being stacked thereon in this order, is characterized in that a recessed structure is placed on the resin layer at a portion having no conductive mesh formed thereon, with a resin layer occupancy R being 5% or more but less than 20%. The present inventors have found that by arranging the resin layer stacked on the conductive layer as described above, a reflection that causes serious influences on the quality of appearance of the display surface to which the filter for a display of the present invention is attached can be effectively prevented without impairing luster thereof. In the filter for a display of the present invention, since the conductive mesh is used as the conductive layer, on each of opening sections of the conductive mesh, the transparent substrate, the hard coat layer and the reflection preventing layer are stacked in this order.

(Structure of Resin Layer)

A resin layer for use in the filter for a display of the present invention is formed on the conductive layer composed of a conductive mesh, and a recessed structure is formed on each of portions of the resin layer where no conductive mesh lines exist. Moreover, on the resin layer for use in the filter for a display of the present invention, the recessed structure is present on each of portions of the resin layer where no conductive mesh lines exist, while a protruding structure is formed on each of portions of the resin layer where conductive mesh lines exist. In the following description, the recessed structure and the protruding structure of the resin layer are combinedly referred to as the recessed structure of the resin layer. Moreover, in the resin layer to be used for the filter for a display of the present invention, the resin layer occupancy R is 5% or more but less than 20%.

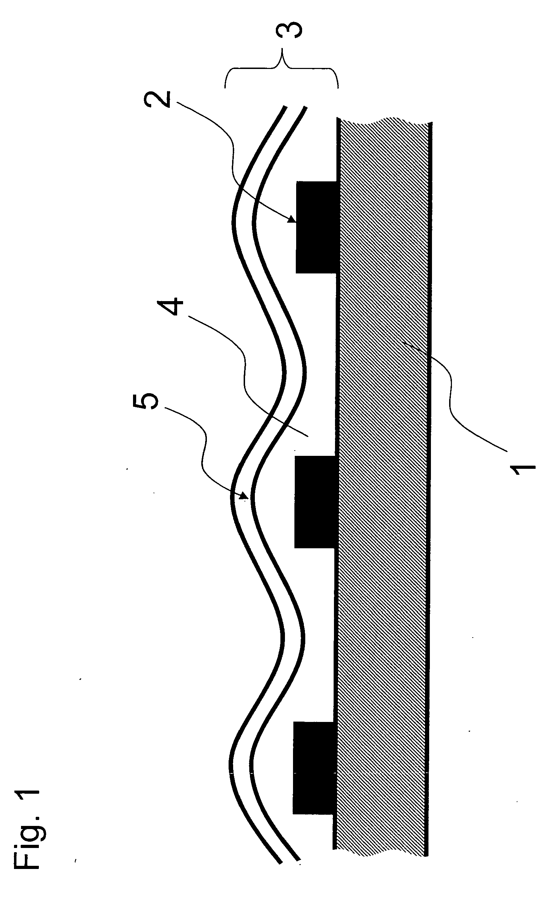

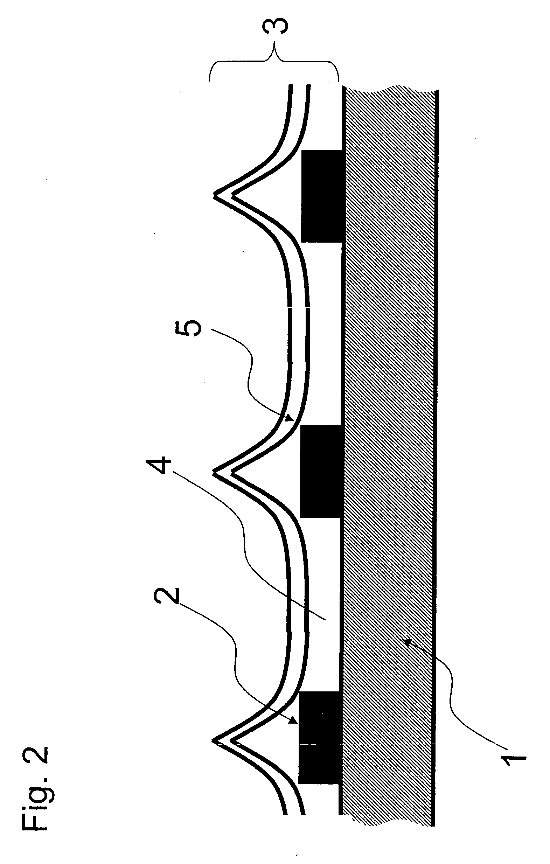

The resin layer occupancy R indicates a ratio of flat portions within an outline of the protruding structure of the resin layer, and as this numeric value becomes greater, the recessed structure (Fig. 1) of the resin layer has smaller flat portions, while as this numeric value becomes smaller, the recessed structure (Fig. 2) of the resin layer has larger flat portions.

The ratio of the flat portions is represented in the following manner. Suppose that, when the cross section of the resin layer is viewed in a direction orthogonal to the transparent base member so as to pass through two centers of gravity (G1, G2) of adjacent opening sections surrounded by the conductive mesh, in a surface direction of the transparent base member, an apex of the resin layer on the conductive mesh located between the center of gravity G1 and the center of gravity G2 is C, that an intersection between a perpendicular (perpendicular relative to the transparent base member) passing through one of the centers of gravity G1 of the two centers of gravity and the surface of the resin layer is A, and that an intersection between a perpendicular (perpendicular relative to the transparent base member) passing through the other center of gravity G2 of the two centers of gravity and the surface of the resin layer is B. Moreover, suppose that the area of a triangle ABC is $\alpha$, and that the area of the resin layer located within the triangle ABC is $\beta$. At this time, the ratio of the area $\beta$ of the resin layer located within the triangle ABC relative to the area $\alpha$ of the triangle ABC is referred to as the resin layer occupancy R ($R = (\beta/\alpha) \times 100$). Referring to Drawings., the following description will discuss the resin layer occupancy R.

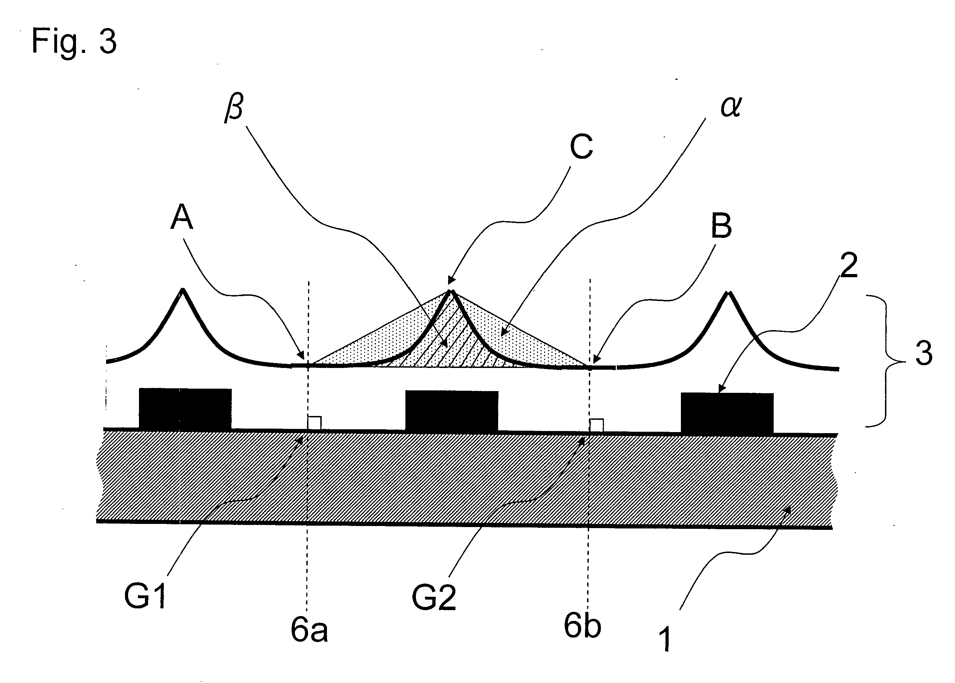

Fig. 3, which is a cross-sectional view showing a filter for a display of the present invention, corresponds to a drawing in which the cross section of a resin layer is viewed in a direction orthogonal to the transparent base member, so as to pass through two centers of gravity (G1, G2) of adjacent opening sections. In Fig. 3, relative to the area ($\alpha$: indicated by dots) of the triangle ABC formed by connecting the apex C of the protruding portion of the resin layer on the conductive mesh located between the centers of gravity G1 and G2, the intersection A between a perpendicular 6a passing through the center of gravity G1 of certain one of opening sections of the conductive mesh and the surface of the resin layer, and the intersection B between a perpendicular 6b passing through the center of gravity G2 of the opening section adjacent to the above-mentioned opening section and the surface of the resin layer, the resin layer occupancy R indicates a ratio of the area ($\beta$: indicated by slanting lines) of the recessed structure of the resin layer located within the triangle ABC.

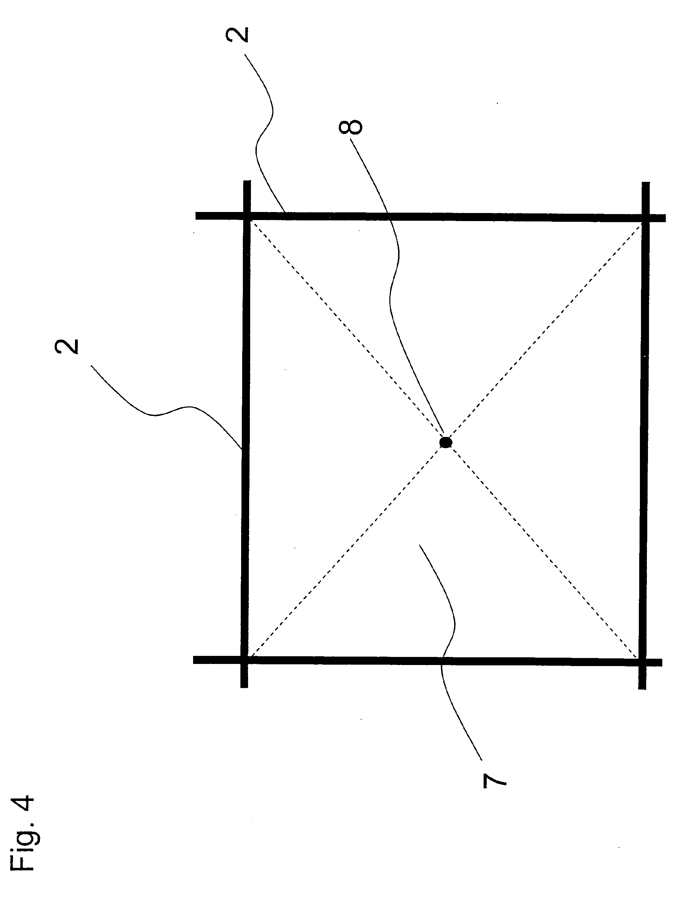

In this case, the center of gravity of the opening section surrounded by the conductive mesh refers to a center of gravity 8 of the opening section 7 of the conductive mesh when the plane of the conductive mesh is viewed in a face direction of the transparent base member, as shown in Fig. 4. Moreover, as shown in Fig. 3, the intersections A and B are intersections between perpendiculars 6a, 6b passing through the center of gravity 8 of the opening section and the surface of the resin layer 3, when viewed the cross section of the resin layer in a direction orthogonal to the transparent base member, passing through the two centers of gravity.

The resin layer occupancy R is represented by the following equation, from the area α of the triangle ABC and the area β of the resin layer located within the triangle ABC.

$$R = (\beta/\alpha) \times 100$$

In order to calculate the resin layer occupancy R, the area P of the resin layer located within the triangle ABC, which corresponds to the area of the recessed structure of the resin layer, and the area α of the triangle ABC can be measured and calculated by a laser microscope (for example, VK-9700, manufactured by KEYENCE Corporation). Three dimensional image data of the resin layer, obtained by observing and measuring a sample by the laser microscope, are further analyzed two-dimensionally in the vertical direction so that a two-dimensional profile is found, and from this two-dimensional profile, the area β of the resin layer located within the triangle ABC and the area α of the triangle ABC can be calculated. At this time, by preliminarily forming an ultra-thin film (uniform film having a thickness of about 50 to 100 nm) made from platinum, palladium, or the like, on the surface of the sample resin layer by sputtering or the like, image data that are free from influences of the conductive mesh and the base member located below the resin layer can be obtained. Specific measuring methods are shown in examples.

In the present invention, it is important to set the resin layer occupancy R to 5% or more but less than 20%, and the resin layer occupancy R is more preferably set to 8% or more but less than 20%. In the case when the resin layer occupancy R is less than 5%, a reflection has its outline clearer so that the reflection tends to be viewed more easily, while in the case when the rate is 20% or more, the degree of roughened surface of the filter becomes too high, with the result that the luster of the filter tends to deteriorate to cause degradation of the quality of appearance of the display; therefore, both of the cases fail to provide a preferable mode.

The resin layer of the filter for a display of the present invention is a resin layer formed by stacking at least a hard coat layer and a reflection preventing layer on a conductive layer in this order. The reflection preventing layer is placed on the outermost surface of the resin layer. The reflection preventing layer of the present invention may be a single layer or multiple layers; however, from an economic viewpoint, and when it is taken into consideration that the surface recessed/protruding shape should be controlled with high precision, the single layer is preferably used. The composition of the reflection preventing layer will be described later.

The surface luminous reflectance of the display filter of the present invention (in this case, the surface luminous reflectance refers to a value from which the influence of reflection from the back surface is eliminated by blackening the back surface of the filter. In this case, the filter back surface refers to a surface on the side opposite to the resin layer relative to the conductive layer) is preferably 0.5 to 4.0%, more preferably 0.5 to 3.0%, most preferably 0.8 to 2.5%, particularly preferably 1.0 to 2.2%. In the case of a surface luminous reflectance of 0.5% or less, the reflection preventing effect exerted by light diffusion of the recessed structure of the resin layer tends to be lowered, while in the case of a surface luminous reflectance exceeding 4.0%, the reflection tends to become glaring due to high reflectance; therefore, the surface luminous reflectance is preferably in the above-mentioned range of 0.5 to 4.0%.

In the case of a conventional filter for a display, the balance between the luminous reflectance of the filter surface and the recessed/protruding shape of the resin layer has not been sufficiently examined, with the result that in the case when the flat portions of the recessed structure of the resin layer is small, the luster becomes poor although the reflection preventing function is superior, while in the case when the flat portions of the recessed structure is large, the reflection preventing function tends to become poor although the luster becomes superior. The inventors of the filter for a display of the present invention have found that by combining a resin layer provided with a surface recessed/protruding shape having Comparatively large flat portions and a reflection preventing layer (additionally, the reflection preventing layer is one portion of the resin layer), the glaringness of the reflection when viewed from the virtually front side can be prevented by the reflection preventing layer, that by using the light diffusing effect of the recessed structure of the resin layer, a reflection appearing when viewed diagonally can be improved effectively, and that in addition to these effects, the effect that the luster of the filter surface is not impaired since the surface structure of the resin layer has large flat portions.

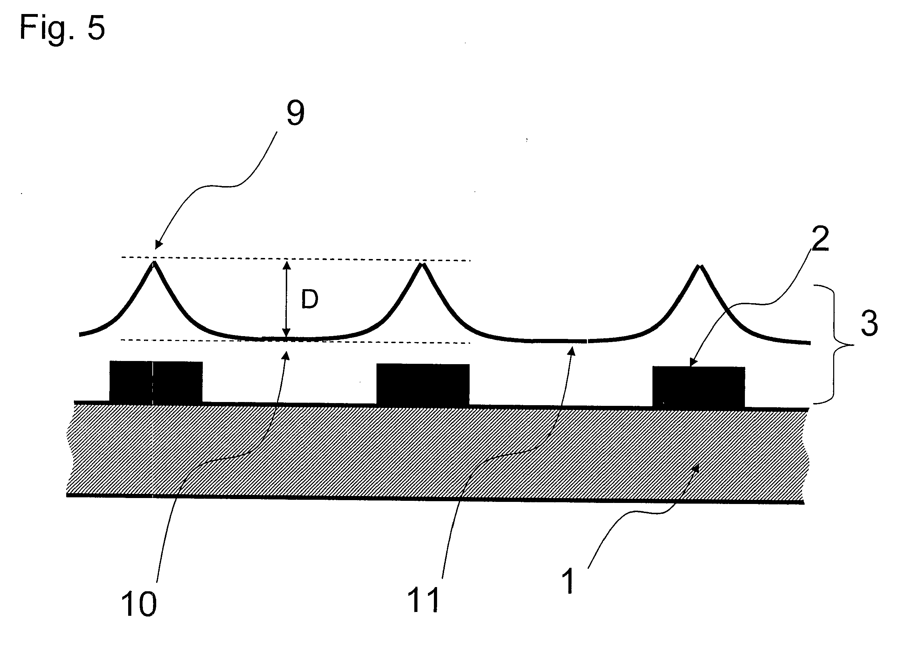

In the filter for a display of the present invention, it is important to provide recessed portions of the resin layer, each having a specific shape, on each of portions where no conductive mesh lines exist. Fig. 5 shows, for example, a structure of recessed portions of the resin layer. In Fig. 5, a conductive mesh 2 (the conductive mesh is a conductive layer) is formed on the transparent base member 1, and the resin layer 3 is further stacked on the conductive mesh 2.

In the conventional reflection preventing technique, onto a smooth flat base member such as a plastic film, a transparent paint containing particles having an average particle size of about 0.5 to 10 μm is applied, and fine irregularities are consequently formed on the surface so that the corresponding technique has been achieved; however, this method fails to sufficiently achieve the reflection preventing technique, without causing a reduction in the luster.

In contrast, the present invention has a conductive layer composed of a conductive mesh, and a resin layer is formed on the conductive layer, and by utilizing irregularities of the conductive mesh, recesses are formed on the resin layer so that reflection preventing characteristics are obtained without the necessity of allowing the resin layer to contain particles, and superior luster can also be simultaneously maintained.

In the case when the recessed structure is simply formed on the resin layer without utilizing the conductive mesh, light is diffused due to the protruding portion of the resin layer to cause reduction in luster; however, the inventors of the present invention have found that, as in the case of the present invention, when the recessed structure is formed on the resin layer including a Comparatively large number of flat portions by utilizing the irregularities of the conductive mesh, the reduction of the luster can be suppressed.

In the present invention, from the viewpoint of effectively preventing reflection, the depth D of the recess of the resin layer is preferably in a range from 0.1 to 5 $\mu$m, more preferably from 0.5 to 4 $\mu$m, most preferably from 0.8 to 3 $\mu$m, particularly preferably from 1 to 2.5 $\mu$m.

As shown in Fig. 5, the depth D of the recess of the resin layer corresponds to a vertical distance from the top 9 to the bottom 10 of the recessed structure of the resin layer. In the present invention, since the recessed structure of the resin layer is formed by utilizing the irregularities of the conductive mesh, the top 9 of the resin layer is positioned on the conductive mesh, while the bottom 10 is positioned a portion where no conductive mesh exists, that is, a portion between the conductive mesh and the conductive mesh (opening section of the conductive mesh).

By setting the depth D of the recess of the resin layer to 0.1 to 5 $\mu$m, the outline of a reflection image becomes unclear, and this structure is preferable because the reflection image can be made hardly visible.

In the present invention, the recessed structure in which the recess is formed at a portion of the resin layer where no conductive mesh exists and the resin layer occupancy R is set to 5% or more but less than 20% can be formed by using a method for controlling the thickness and pitch of the conductive mesh as well as a method for controlling the viscosity of a coating solution used for forming the resin layer, or the like. The detailed description thereof will be given later.

The present invention provides recesses (recessed structure) on the resin layer without the necessity of allowing the resin layer to contain particles, and makes it possible to prevent reflection by using this structure; however, particles may be contained in the resin layer for the purpose of adjusting the reflection preventing effect. In this case, however, by allowing the resin layer to contain particles, the luster tends to deteriorate. Therefore, in an attempt to improve the reflection preventing effect by allowing the resin layer to contain particles, it is necessary to carefully select the average particle size and the content of the particles so as not to deteriorate the luster. Additionally, upon allowing the resin layer to contain particles, the particles may be contained in either of the hard coat layer and the reflection preventing layer.

When particles are contained in the resin layer, those particles having an average particle size in a range from 0.5 to 5 $\mu$m are preferably used, and in particular, those in a range from 1 to 3 $\mu$m are more preferably used.

The average particle size of particles is given as an average value of particles sizes represented by sphere-corresponding values measured by, for example, an electric resistance testing method (Coulter Counter method).

Moreover, when particles are contained in the resin layer, the average particle size of the particles is preferably in a range from 0.5 to 5 $\mu$m, and those particles having an average particle size that is the same as, or the same or less of the thickness of the conductive mesh are preferably used; in particular, those particles having an average particle size of 90% or less, relative to 100% of the thickness of the conductive mesh are preferably used, more preferably, thoseparticleshaving an average particle size of 80% or less relative to the thickness of the conductive mesh are used, and most preferably, those particles having an average particle size of 70% or less are used.

In the case when particles are contained in the resin layer, the content of the particles is preferably 6% or less by mass, more preferably 4% or less by mass, most preferably 3% or less by mass, particularly preferably 2. 5% or less by mass, relative to 100% by mass of all the components of the resin layer.

As the particles to be contained in the resin layer, those of inorganic type and organic type are exemplified, and those made from an organic material are preferably used. Moreover, those having superior transparency are preferably used. Specific examples of the particles include silica beads as the inorganic type, and plastic beads as the organic type. Furthermore, among the plastic beads, those having superior transparency are preferably used. Specific examples thereof include acryl-based, styrene-based, melamine-based materials or the like. In the present invention, those acryl-based materials that are superior in transparency are preferably used.

Those having a spherical shape (true spherical shape, elliptical shape or the like) are preferably used, and those having the true spherical shape are more preferably use.

The surface roughness Ra of the outermost surface of the resin layer of the display filter of the present invention is preferably 15 to 400 nm, more preferably, 20 to 300 nm, most preferably 30 to 200 nm, particularly preferably 40 to 100 nm. In the case of Ra of 15 nm or less, the reflection preventing characteristics become poor, and in the case of Ra exceeding 400 nm, the luster becomes deteriorate; therefore, these cases are not preferable.

The reflection image on the display panel is composed of reflected light from the filter for a display and reflected light from the display panel. Since the reflected light from the display panel is absorbed by the filter for a display, the reflection performance can be improved by lowering the transmittance of the filter for a display. In the case when the transmittance of the filter for a display is lowered too much, however, the luminance of a transmitted image also becomes low to make the image dimmer, and in order to maintain the luminance in such a case, it is necessary to make the image to be displayed on the display panel brighter, and this is not a preferable mode since the power consumption consequently becomes higher. Therefore, the transmittance of all the light rays of the filter for a display of the present invention is preferably 20 to 70%, more preferably 30 to 60%, most preferably 35 to 55%. By setting the transmittance to these ranges, the balance between the reduction of reflection and the luminance of the transmitted image can be desirably maintained.

(Conductive Layer)

From the viewpoint of static charge preventing characteristics, various conductive layers are installed on the filter for a display, and in particular, in the case of a plasma display panel, strong leak electromagnetic waves are generated from its structure and operation principle. In recent years, public attention has been focused on influences of leak electromagnetic waves given to the human body and other apparatuses from electronic apparatuses, and, for example, in Japan, the leak electromagnetic waves need to be limited to a reference value or less of VCCI (voluntary control council for interference by processing equipment electronic office machine). More specifically, in VCCI, the radiation electromagnetic field intensity is less than 50 dBμV/m in class A indicating the regulated value for business application, and it is less than 40 dBμV/m in class B indicating the regulated value for consumer application; however, since the radiation electromagnetic field intensity of the plasma display panel exceeds 50 dBμV/m (in the case of 40 inches in diagonal length) within a band of 20 to 90 MHz, the plasma display panel in this state cannot be used for household application. For this reason, it is necessary for the plasma display panel to install a filter for a plasma display provided with an electromagnetic wave shielding layer (conductive layer).

The electromagnetic wave shielding layer requires conductivity so as to exert an electromagnetic wave shielding performance, and the conductivity required for the electromagnetic shielding of the plasma display panel is 3 Ω/sq or less in sheet resistivity, more preferably 1 Ω/sq or less, most preferably 0.5 Ω/sq or less. Therefore, the display for a filter of the present invention having a conductive layer is preferably 3 Ω/sq or less in sheet resistivity, more preferably 1 Ω/sq or less, most preferably 0.5 Ω/sq or less. Moreover, in order to improve the electromagnetic wave shielding characteristics, the lower the sheet resistivity, the better; however, in practice, the lower limit value is considered to be about 0.01 Ω/sq.

In the filter for a display of the present invention, the conductive mesh is used as the conductive layer. By using the conductive mesh, the protruding portions with the conductive mesh located therein and the recessed portions with no conductive mesh located therein can be utilized so that it is possible to form recesses in the resin layer at the portions where no conductive mesh exists.

In addition to the function for shielding electromagnetic waves, the conductive layer composed of the conductive mesh in accordance with the present invention also has a function for forming the recesses in the resin layer as described above.

In order to form recesses that effectively exert the reflection preventing characteristics, the thickness of the conductive mesh needs to be made larger to a certain extent; in contrast, when the thickness becomes too large, the luster tends to be lowered, and the coating property of the resin layer deteriorates to sometimes cause coat streaks and irregularities.

From the viewpoints described above, the thickness of the conductive mesh is preferably in a range from 0.5 to 8 μm, more preferably from 1 to 7 μm, most preferably from 1 to 5 μm, particularly preferably from 1 to 3 μm. In the case of the thickness of the conductive mesh of less than 0.5 μm, the depth of the recess in the resin layer becomes insufficient, and the outline of a reflection image becomes clearer, with the result that the reflection image tends to be easily viewed, and that sufficient electromagnetic wave shielding characteristics cannot be obtained. Moreover, in the case of the thickness of the conductive mesh exceeding 8 μm, the depth of the recess in the resin layer becomes too large, and the luster tends to deteriorate to cause high costs disadvantageously.

From the viewpoint of coating property of the resin layer, the smaller the thickness of the conductive mesh, the better. Therefore, by setting the thickness of the conductive mesh to 8 μm or less, it is possible to provide a preferable coated surface without causing coat streaks and coat irregularities. In the case of the thickness of the conductive mesh exceeding 8 μm, since the coating property of the resin layer is lowered, it becomes difficult to form recesses that are effective for reflection prevention and luster retention on the resin layer in a stable manner.

Moreover, with respect to the pitch of the conductive mesh, from the viewpoint of forming recesses that are effective for reflection prevention and luster retention in the resin layer, there is a preferable range of the pitch. In this case, the pitch of the conductive mesh refers to a distance of a portion (opening section surrounded by thin lines of the conductive mesh) where no conductive mesh exists, and more specifically, this distance corresponds to a distance between centers of gravity between this opening section and an adjacent opening section with one side being commonly possessed by this opening section.

In the present invention, the pitch of recesses formed in the resin layer greatly depends on the pitch of the conductive mesh. Therefore, by controlling the pitch of the conductive mesh, recesses, which are effective for reflection prevention, can be formed on the resin layer. The pitch of the recesses of the resin layer refers to a distance between bottoms of the resin layer, and, more specifically, as shown in Fig. 5, it corresponds to a distance between one bottom 10 of a certain recess and another bottom 11 of another recess adjacent thereto.

From the above-mentioned viewpoints, the pitch of the conductive mesh is preferably in a range from 50 to 500 $\mu$m, more preferably from 75 to 450 nm, most preferably from 100 to 350 $\mu$m.

The line width of the conductive mesh in accordance with the present invention is preferably in a range from 3 to 30 $\mu$m, more preferably from 5 to 20 $\mu$m. In the case of the line width smaller than 3 $\mu$m, the magnetic wave shielding characteristics tend to be lowered, while in the case of the line width exceeding 30 $\mu$m, the transmittance of the filter for a display tends to be lowered. Since the electromagnetic wave shielding property and the transmittance are also influenced by the pitch of the conductive mesh, the line width and the pitch are preferably adjusted within the above-mentioned ranges.

The transmittance of the filter for a display is greatly influenced by the aperture ratio of the conductive mesh. The aperture ratio of the conductive mesh corresponds to a ratio between the total area of the mesh portion (thin line portions) when viewed on the plane and the total area of the opening portions when viewed on the plane, and the aperture ratio of the conductive mesh is determined by the line width and the pitch. In the present invention, the aperture ratio of the conductive mesh is preferably 60% ormore, more preferably 70% ormore, particularly preferably 80% or more. The upper limit of the aperture ratio is preferably 95% or less, more preferably 93% or less.

The aperture ratio of the conductive mesh is measured, for example, in the following manner.

By using a digital microscope (VHX-200) manufactured by KEYENCE Corporation, a surface observation is carried out at a magnification of 200 times, and by using its luminance extraction function (histogram extraction, luminance range setting 0-170), portions (opening sections) where no conductive mesh exits and portions where the conductive mesh exists are binarized, and by successively using its areameasuring function, the area of the entire portion and the area of the opening section are calculated; thus, by dividing the area of the opening sections by the area of the entire portion, the aperture ratio is found.

More specifically, from one sheet of a sample having a size of 20 cm $\times$ 20 cm, aperture ratios are calculated at arbitrary 20 portions, and an average value thereof is preferably obtained.

The shape of the mesh pattern of the conductive mesh (shape of the opening section) includes, for example, lattice-shaped mesh patterns made by rectangular shapes, such as a square, a rectangle and a rhombic shape; mesh patterns composed of polygonal shapes, such as a triangular shape, a pentagonal shape, a hexagonal shape, an octagonal shape and a dodecagonal shape; mesh patterns composed of a round shape and an elliptical shape; mesh patterns made of composite shapes of these; and random mesh patterns. Among these, lattice mesh patterns of rectangular shapes and lattice mesh patterns having a hexagonal shape are preferably used, and regular mesh patterns are more preferably used.

In the case when, for example, the mesh pattern is a lattice pattern, so as to prevent the mesh pattern from causing a moire pattern interference due to the interaction with display pixels that are arranged side by side longitudinally as well as laterally, the lines of the mesh pattern are preferably allowed to have a certain degree of angle (bias angle) relative to the lines along which the pixels are aligned. Since the bias angle that can prevent the moire pattern interference varies depending on the pitch of the pixels, and the pitch and line width of the mesh pattern, it is preferably set on demand in response to these conditions.

In the filter for a display of the present invention, the conductive layer composed of the conductive mesh is formed on a transparent base member, as the transparent base member, various kinds of films, obtained by using a solution film-forming method and a fusion film-formingmethod, may be used, and detailed descriptions of the transparent base member will be described later.

In the filter for a display of the present invention, as the method for forming the conductive layer composed of the conductive mesh on the transparent base member or the like, various known methods may be used. Examples of the methods include: 1) a method in which a conductive ink is printed on a transparent base member as a pattern; 2) a method in which, after having been pattern-printed by using an ink containing a catalyst core for plating, a plating process is carried out; 3) a method using conductive fibers; 4) a method in which, after a metal foil has been bonded to a base member by an adhesive, the resulting layer is patterned; 5) a method in which after a metal thin film has been formed on a base member by using a vapor-phase film-forming method or a plating method, the resulting film is patterned; 6) a method using photosensitive silver salt; and 7) a method in which a metal thin film is subjected to laser abrasion; however, the present invention is not intended to be limited to these methods.

The following description will discuss a method for manufacturing the conductive mesh in detail.

1) As the method for printing a conductive ink on the transparent base member as a pattern, a method is proposed in which the conductive ink is printed on the transparent base member by using a known printing method, such as a screen printing method and a gravure printing method as a pattern.

2) As the method in which, after a pattern has been printed by using an ink containing a catalyst core for plating, a plating process is carried out, for example, a method is proposed in which, after a pattern has been printed by using a catalyst ink composed of, for example, a paste containing palladium colloid, the resultant film is immersed into a electroless copper plating solution so as to be subjected to an electroless copper plating process, and then subjected to an electrolytic copper plating process, and further subjected to an electrolytic plating process of an Ni-Sn alloy so that a conductive mesh pattern is formed.

3) As the method using conductive fibers, a method is proposed in which a knitted cloths made from conductive fibers are bonded to each other by using an adhesive or a sticker material.

4) As the method in which, after a metal foil has been bonded to a transparent base member by using an adhesive, the resultant film is patterned, a method is proposed in which, after a metal foil (copper, aluminum, nickel, or the like) has been bonded to a transparent base member by using an adhesive or a sticker material, the resultant metal foil is formed into a resist pattern by utilizing a photolithographic method, a screen printing method, or the like so that the resultant metal foil is then etched. As the method for forming the resist pattern, the photolithographic method is preferably used, and the photolithographic method is a method in which, after a photosensitive resist has been applied to a metal foil or after a photosensitive resist film has been laminated thereon, the resultant film is subjected to an exposing process, with a pattern mask being made tightly in contact therewith, so that an etching resist pattern is formed, and the metal located other than the pattern portion is eluted by using an appropriate etching solution so that a desired conductive mesh is formed.

5) As the method in which, after a metal thin film has been formed on a base member by using a vapor-phase film-forming method or a plating method, the resulting film is patterned, a method is proposed in which, after a metal thin film (metals, such as copper, aluminum, silver, gold, palladium, indium, tin, or silver, and alloys of these with metals other than these) has been formed on a transparent base member by using a vapor-phase film-forming method, such as vapor deposition, sputtering, and ion plating, or a plating method, and after a resist pattern has been formed on the metal thin film by utilizing a photolithographic method, a screen printing method or the like, the resultant metal thin film is etched. As the above-mentionedmethod in which the resist pattern is used, the photolithographic method is preferably used, and the photolithographic method is a method in which a photosensitive resist is applied onto a metal thin film or a photosensitive resist film is laminated thereon, and, after this has been exposed, with a pattern mask being made in tightly contact therewith, the resultant film is developed by using a developing solution to form an etching resist pattern, and metal other than the patterned portion is further eluted by using an appropriate etching solution so that a desired conductive mesh is formed. In this method, without the necessity of using an adhesive and a sticker, a metal thin film can be desirably formed on a transparent base member.

6) As the method in which a photosensitive silver salt is used, a method is proposed in which a silver salt emulsion layer, made from halogenated silver, is coated on a transparent base member, and after this has been subjected to a photomask exposing process or a laser exposing process, the resultant layer is developed to form a silver mesh. The silver mesh thus formed is preferably further plated with metal suchas copper, and nickel. Thismethod has been described in International Publication No. WO2004/07810 Pamphlet, JP-A No. 2004-221564 and JP-A No. 2006-12935, which can be referred to.

7) As the method in which a metal thin film is subjected to laser abrasion, a method is proposed in which a metal thin film, formed on a transparent base member by using the same method as method 5), is subjected to a laser abrasion method so that a mesh pattern of a metal thin film is formed.

Among the manufacturing methods for the conductive mesh, from the viewpoints that a conductive mesh having a Comparatively small thickness (for example, a conductive mesh having a thickness of 8 $\mu$m or less) can be easily manufactured and that the resultant mesh ensures a high electromagnetic wave shielding characteristics, the manufacturing methods 2), 5), 6) and 7) are desirably used.

Moreover, from the viewpoints of coating property of the resin layer, and adhesion between the resin layer and the conductive layer, those meshes, manufactured by using the above-mentioned methods 2), 5) and 7), are desirably used. In particular, the manufacturing method 5) provides a good coating characteristics of the resin layer, and since this method also provides low manufacturing costs of the conductive mesh, it is, in particular, desirably used.

The following description will discuss the manufacturing method 5) in more detail.

As a method for forming a metal thin film on a transparent base member, the vapor-phase film-forming method is preferably used. Examples of the vapor-phase film-forming method include: a sputtering method, an ion plating method, an electron beam vapor deposition method, a vacuum vapor deposition method and a chemical vapor deposition method, and among these, the sputtering method and the vacuum vapor deposition method are preferably used. As the metal used for forming the metal thin film, amongmetals, such as copper, aluminum, nickel, iron, gold, silver, stainless, chromium and titanium, one kind may be used, or an alloy in which two or more kinds of these are combined with one another, or those formed into a multilayer may be used. Among these, copper is preferably used because of its good electromagnetic wave shielding characteristics, easiness in mesh pattern processing, and low costs.

In the case when copper is used as metal for a metal thin film, a nickel thin film having a thickness of 5 to 100 nm is preferably interposed between the base member and the copper thin film. Thus, the adhesion between the base member and the copper thin film can be improved.

Moreover, on the surface of the metal thin film, a metal compound, such as metal oxide, metal nitride, and metal sulfide, may be stacked by using the vapor film-forming method. By stacking the metal compound, a blackening process, which will be described later, is desirably omitted. Examples of the metal compound include: oxides, nitrides, or sulfides of metals, such as gold, platinum, silver, mercury, copper, aluminum, nickel, chromium, iron, tin, zinc, indium, palladium, iridium, cobalt, tantalum, antimony and titanium.

The thickness of the metal compound is preferably in a range from 5 to 200 nm, more preferably from 10 to 100 nm. This metal compound layer and the aforementioned nickel thin film are allowed to form one portion of the metal thin film, and further form one portion of the conductive mesh.

As the method for forming the resist pattern on the metal thin film, photolithography is preferably used. Such a photolithographic method refers to a method in which a photosensitive resist layer is stacked on a metal thin film, and the resist layer is exposed into a mesh pattern, and developed so that a resist pattern is formed, and the metal thin film is then etched into a mesh pattern so that the resist layer on the mesh is separated and removed.

As the photosensitive resist layer, a negative-working resist in which the exposed portion is cured, or in contrast, a positive-working resist in which the exposed portion is dissolved by development may be used. The photosensitive resist layer may be directly applied onto a metal thin film and stacked thereon, or a film made from photoresist may be bonded thereto. As the method for exposing the photoresist layer, a method for exposing it by ultraviolet rays with a photomask interposed therebetween, or a method in which it is directly scanned and exposed by using a laser may be used.

Moreover, a black pigment such as carbon black and titanium black may be contained in the resist layer so as to be blackened. The black resist layer may be left, as it is, on the conductive mesh, without being removed, so that the blackening process, which will be described later, is preferably omitted.

As the etching method, for example, a chemical etching method is proposed. The chemical etching method refers to a method in which the metal other than the metal portion protected by a resist pattern is dissolved by an etching solution, and removed. As the etching solution, a ferric chloride aqueous solution, a cupric chloride aqueous solution, an alkali etching solution or the like may be used.

The conductive mesh in accordance with the present invention is preferably subjected to a blackening process. By applying the blackening process thereto, reflection from the viewer side due to metal luster of the conductive mesh and reflection from the display side can be reduced, and the reduction in image visibility can be further reduced so that a filter for a display that is superior in contrast and visibility can be obtained.

With respect to the conductive mesh, portions other than the portion that forms a light transmitting portion when placed on a display, that is, those portions other than the display portion and portions concealed by a frame printed portion, are not necessarily required to have the mesh pattern, and these portions may form, for example, a metal foil solid portion with no pattern formed thereon. In addition, in the case when the solid portion having no pattern has a black color, the portion, as it is, may be desirably used as the frame printed portion for a filter for a display.

(Lamination of Resin Layer)

In the present invention, a resin layer is laminated on a conductive layer composed of a conductive mesh, and preferably, the resin layer is directly laminated on the conductive layer. Moreover, it is important for the resin layer on the conductive layer to have a structure in which a hard coat layer and a reflection preventing layer are laminated thereon in this order (in such an order that the reflection preventing layer is laminated as the outermost surface). As the lamination method for the resin layer, a coating solution to form the resin layer (hereinafter, referred to simply as "coating solution") is preferably applied thereto.

Upon carrying out a coating process, the viscosity of the coating solution (23°C) is preferably set in a range from 1 to 50 mPa·s. By controlling the viscosity of the coating solution in this range, it is possible to form recesses that can effectively prevent reflection on the resin layer and a recessed structure having a resin layer occupancy R in a range from 5% or more but less than 20%. In an attempt to form the recessed structure on the resin layer, it is effective to set the viscosity of the coating solution to 50 mPa·s or less. In the case of the viscosity of the coating solution exceeding 50 mPa·s, the coating characteristics deteriorate to sometimes cause coat streaks and irregularities. When the viscosity of the coating solution is lower than 1 mPa·s, the coated surface is easily flattened, failing to form recesses that can effectively prevent reflection and easily causing a coating defect such as repellency. The viscosity of the coating solution is preferably in a range from 1 to 40 mPa·s, more preferably from 1 to 30 mPa·s, most preferably from 1 to 20 mPa·s.

In the present invention, it is preferable to control the volume coated amount of the resin layer in a dried state depending on the thickness of the conductive mesh. With this arrangement, it is possible to form recesses capable of effectively preventing reflection on the resin layer at portions (opening sections of the conductive mesh) where no conductive mesh exists. Supposing that the thickness of the conductive mesh is X ($\mu$m), a theoretical volume coated

amount Y (cm$^3$/m$^2$) of the resin layer in the case when the resin layer is evenly filled only in the opening section of the conductive mesh to the same height as the thickness of the conductive mesh is represented by the following equation. In the following equation, Z represents the aperture ratio of the conductive mesh. Moreover, m$^2$ = 10$^{12}$ $\mu$m$^2$, and $\mu$m$^3$ = 10$^{-12}$ cm$^3$.

$$Y = (X \times 10^{12}) \times Z \times 10^{-12} = X \times Z$$

The preferable range of the volume coated amount of the resin layer in accordance with the thickness of the conductive mesh can be found based upon the above-mentioned theoretical volume coated amount Y. That is, the volume coated amount of the resin layer is preferably in a range from 80 to 600%, more preferably from 150 to 500%, particularly preferably from more than 250% to 500% or less, relative to 100% of the theoretical volume coated amount Y. By controlling the volume coated amount within the above-mentioned range relative to the theoretical volume coated amount, it becomes possible to form recesses capable of effectively preventing reflection and a recessed structure having a resin layer occupancy R in a range from 5% or more but less than 20% on the resin layer. In the case when the volume coated amount of the resin layer becomes smaller than 80% relative to 100% of the theoretical volume coated amount Y, the surface recessed structure tends to be roughened, with the result that the luster tends to deteriorate, and in the case when the volume coated amount becomes greater than 600%, it becomes difficult to form the recesses capable of effectively preventing reflection; therefore, neither of these conditions are preferable. The above-mentioned volume coated amount corresponds to a volume coated amount after the drying process; however, in the case when the resin layer is a hard coat layer, the volume coated amount corresponds to a volume coated amount after the curing process.

Moreover, in the present invention, the depth D of the recesses of the resin layer is preferably 0.1 to 5 $\mu$m, and in the case when the thickness of the conductive mesh is in a range from 0.5 to 8 $\mu$m, the depth range can be achieved by setting the volume coated amount to 80 to 600% relative to the theoretical volume coated amount.

Moreover, with respect to the solid component concentration of the coating solution and the wet coated amount of the coating solution as well, adjustments are preferably made in the following ranges. The solid component concentration of the coating solution is preferably in a range from 10 to 80% by mass, more preferably 20 to 70% by mass, particularly preferably 30 to 70% by mass. In this case, as the solid components in the coating solution, a resin component, and other solid components (for example, a polymerization initiator, a coating characteristic improving agent, or the like) are contained on demand. Examples of the resin component include a polymer, a monomer and an oligomer, and the resin components are preferably contained at 50% by mass or more, more preferably 60% by mass or more, relative to the total solid components in the coating solution. The upper limit thereof is 100% by mass. The wet coated amount of the coating solution is preferably in a range from 1 to 50 g/m$^2$, more preferably from 3 to 40 g/m$^2$, particularly preferably from 5 to 30 g/m$^2$.

As the coating method for the coating solution for a resin layer, various kinds of coatingmethods, such as a reverse coating method, a gravure coating method, a rod coating method, a bar coating method, a die coating method, a spray coating method, or the like, maybe used. Among these, the gravure coatingmethod and the die coating method are preferably used.

In the present invention, the resin layer contains a hard coat layer. The hard coat layer has a function for preventing scratches and the like from occurring on the filter for a display, and for this reason, it preferably has sufficiently high hardness.

In order to obtain high hardness, a polyfunctional polymerizable monomer is preferably used as the resin component of the hard coat layer, the hard coat layer thus formed preferably has a specific weight after having been cured of 1.2 or more, more preferably 1.3 or more, most preferably 1.4 or more. As the specific weight after the curing process becomes higher, the hardness tends to become higher; therefore, the higher the specific weight of the hard coat layer after the curing process, the better. The upper limit of the specific weight of the hard coat layer is about 1.7.

When the volume coated amount of the resin layer is multiplied by the specific weight, the resulting value corresponds to amass coated amount. Since the mass coated amount of the resin layer can be easily found by measuring the masses of a sample per unit area before and after the coating process, it is preferably used for controlling and managing the manufacturing processes.

For example, supposing that the thickness X of the conductive mesh is 5 $\mu$m and that the aperture ratio Z of the conductive mesh is 85%, with the specific weight of the hard coat layer after the curing process being set to 1.4, the theoretical volume coated amount Y of the resin layer is represented by:

$$Y = X \times Z = 5 \times 0.85 = 4.25 \ \text{cm}^3/\text{m}^2$$

In the present invention, the thickness of the conductive mesh is preferably 8 $\mu$m or less, as described earlier. In the case when the thickness of the conductive mesh becomes larger than 8 $\mu$m, upon coating the resin layer on the conductive mesh in an actual manufacturing process, the coating characteristics is seriously lowered to cause occurrences of streaks and irregularities on the coating surface of the resin layer, and also to make flat portions on the resin layer smaller sometimes resulting in adverse influences to the luster. In particular, when the dried coated amount of the resin layer is made smaller so as to form recesses on the resin layer, the degradation of the coating characteristics becomes conspicuous. When coat streaks and irregularities occur on the resin layer, crucial disadvantages occur in the filter for a display.

In the case when the thickness of the conductive mesh is larger than 8 $\mu$m, in order to maintain a desired coating characteristics of the resin layer, the mass coated amount (after the drying process) of the resin layer needs to be set to 20 g/m$^2$ or more, with the result that the productivity is lowered seriously due to increases of the drying time and curing time after the coating process. Moreover, in the case when the resin layer contains a hard coat layer, upon increase in the mass coated amount (mass coated amount after the curing process in the case of a hard coat layer) as described above, problems are raised in that curling occurs in the filter for a display due to polymerization contraction at the time of the curing process, and in that a crack occurs in the hard coat layer. By appropriately adjusting the drying conditions, such as drying time, it becomes possible to form recesses capable of effectively preventing reflection on the resin layer and a recessed structure having a resin layer occupancy in a range from 5% or more but less than 20%. In this case, with respect to the preferable drying conditions that depend on the viscosity of the coating solution, the volume coated amount and the like, the drying temperature is preferably in a range from 80 to 150°C, more preferably from 100 to 130°C, and the drying time is preferably from 30 to 90 seconds, within the above-mentioned ranges of the viscosity and the volume coated amount.

In the present invention, the mass coated amount of the resin layer is preferably 16 g/m$^2$ or less, more preferably 14 g/m$^2$ or less, most preferably 10 g/m$^2$ or less, particularly preferably 9 g/m$^2$ or less. From the viewpoint of maintaining the hardness of the resin layer, the lower limit of the mass coated amount of the resin layer is preferably 1 g/m$^2$ or more, more preferably 1.5 g/m$^2$ or more. The resin layer of the filter for a display of the present invention has a laminated structure having at least two layers of a hard coat layer and a reflection preventing layer. For this reason, the description of the mass coated amount is equivalent to the description of the mass coated amount of the hard coat layer corresponding to one layer on the side closest to the conductive layer, or the other layer.

Examples of the laminated structure pattern of the resin layer to be laminated on the conductive layer of a filter for a display of the present invention include: low refractive index layer/hard coat layer; low refractive index layer/high refractive index layer/hard coat layer; low refractive index layer/high refractive hard coat layer; antifouling layer/low refractive index layer/hard coat layer; static charge preventing layer/low refractive index layer/hard coat layer; low refractive index layer/colored hard coat layer/hard coat layer; low refractive index layer/high refractive index layer/colored hard coat layer/hard coat layer, and the like (in these laminated structures of the resin layers, the layer described on the left side is located closest to the viewer side, and the layer described on the right side is located closest to the conductive layer side. That is, in the case of the "low refractive index layer/hard coat layer", this structure means that the low refractive index layer is disposed on the viewer side, while the hard coat layer is disposed on the conductive layer side). However, the present invention is not intended to be limited to these.

(Hard Coat Layer)

The hard coat layer is a layer that is formed so as to prevent scratches. The hard coat layer is preferably designed to have high hardness, and is preferably H or more in the pencil hardness defined in JIS K5600-5-4 (1999), and more preferably 2H or more. The upper limit is set to about 9H.

Moreover, in order to easily evaluate the scratch resistant property, a scratch resistant test by the use of steel wool may be used. In this test method, on the surface of a hard coat layer, a load of 250 g is imposed on steel wool of #0000, and after this has been frictionally moved 10 times reciprocally, with a stroke width of 10 cm, at a speed of 30 mm/sec, the surface thereof is visually observed, and scratches formed thereon are evaluated in 5 stages.

Class 5: No scratches were formed.
Class 4: One or more to five or less scratches were formed.
Class 3: Six or more to ten or less scratches were formed.
Class 2: Eleven or more scratches were formed.
Class 1: Innumerable scratches were formed on the entire surface.

In the above-mentioned test method, the hard coat layer is preferably set to class 3 or higher, more preferably to class 4 or higher.

As the resin component forming the hard coat layer of the present invention, a thermosetting resin, such as an acryl-based resin, a silicon-based resin, a melamine-based resin, an urethane-based resin, an alkyd-based resin and a fluorine-based resin, or a photo-curable resin and the like may be used, and when balances among the performance, cost, productivity and the like are taken into consideration, the acryl-based resin is preferably adopted.

The hard coat layer to be formed by the acryl-based resin is made of a curing composition mainly composed of a polyfunctional acrylate. The polyfunctional acrylate is a monomer, or an oligomer or a prepolymer having 3 (preferably 4, more preferably 5) or more (meth)acryloyloxy groups in one molecule, and as the monomer, or oligomer, or prepolymer having 3 or more (meth)acryloyloxygroups (inthepresentspecification, the term "...(meth)acryl..." represents an abbreviation of "... acryl ... , or ...methacryl..."), for example, a compound or the like in which, in polyhydric alcohol having three or more alcohol-based hydroxide groups in one molecule, the hydroxide group forms three or more esterified (meth)acrylic acids is exemplified.

Specific examples thereof include: pentaerythritol tri(meth)acrylate, pentaerythritol tetra(meth)acrylate, dipentaerythritol tri(meth)acrylate, dipentaerythritol tetra(meth)acrylate, dipentaerythritol penta(meth) acrylate, dipentaerythritol hexa(meth)acrylate, trimethylolpropane tri(meth)acrylate, trimethylolpropane EO-modified tri (meth) acrylate, pentaerythritol triacrylate hexamethylene diisocyanate urethane prepolymer, pentaerythritol triacrylate toluene diisocyanate urethane prepolymer, pentaerythritol triacrylate isophorone diisocyanate urethane prepolymer, and the like. One kind of these may be used, or two or more kinds of these may be used as a mixture.

The ratio of use of the monomer, oligomer and prepolymer having three or more (meth) acryloyloxy groups in each molecule is preferably in a range from 50 to 90% by mass, more preferably from 50 to 80% by mass, relative to 100% by mass of the total amount of the hard coat layer constituent components.

In addition to the above-mentioned compound, in order to alleviate the rigidity of the hard coat layer and also to alleviate contraction upon curing, a mono- or difunctional acrylate group is preferably used in combination. As the monomer having one or two ethylenically unsaturated double bonds in one molecule, not particular limited, any normal monomer may be used, as long as it is radically polymerizable.

As the compound having two ethylenically unsaturated double bonds in each molecule, the following (a) to (f) (meth)acrylates or the like may be used.

(a) (meth)acrylic diesters of alkylene glycol having 2 to 12 carbon atoms: ethylene glycol di(meth)acrylate, and propylene glycol di(meth) acrylate, and the like,
(b) (meth)acrylic diesters of polyoxyalkylene glycol: diethylene glycol di(meth)acrylate, triethylene glycol di(meth) acrylate, and the like,
(c) (meth)acrylic diesters of polyhydric alcohol: pentaerythritol di(meth)acrylate, and the like,
(d) (meth) acrylic diesters of ethylene oxide and propylene oxide adducts of bisphenol A or hydrides of bisphenol A: 2,2'-bis(4-acryloxyethoxyphenyl) propane, 2,2'-bis(4-acryloxy propoxyphenyl) propane, and the like,
(e) urethane (meth)acrylates having two or more (meth) acryloyloxy groups in each molecule, obtained by allowing a compound containing a terminal isocyanate group, obtained by preliminarily allowing a diisocyanate compound with two or more compounds containing alcohol-based hydroxyl groups, to further react with (meth)acrylate containing alcohol-based hydroxyl groups, and the like, and
(f) epoxy (meth) acrylates having two or more (meth) acryloyloxy groups in each molecule, obtained by allowing a compound having two or more epoxy groups in each molecule to react with acrylic acid or methacrylic acid, and the like.

Examples of the compound having one ethylenically unsaturated double bonds in each molecule include: methyl (meth)acrylate, ethyl (meth)acrylate, n- and i-propyl (meth)acrylate, n-, sec-, and t-butyl (meth)acrylate, 2-ethylhexyl (meth)acrylate, lauryl (meth)acrylate, stearyl (meth)acrylate, methoxyethyl (meth)acrylate, ethoxyethyl (meth)acrylate, hydroxyethyl (meth)acrylate, polyethylene glycol mono(meth)acrylate, polypropylene glycol mono(meth)acrylate, glycidyl (meth)acrylate, tetrahydrofurfuryl (meth)acrylate, N-hydroxyethyl (meth)acrylamide, N-vinyl pyrrolidone, N-vinyl-3-methyl pyrrolidone, N-vinyl-5-methyl pyrrolidone, and the like. One kind of these monomers may be used or two or more kinds thereof may be used as a mixture.

The ratio of use of the monomer having one or two ethylenically unsaturated double bonds in each molecule is preferably in a range from 10 to 40% by mass, more preferably from 20 to 40% by mass, relative to 100% by mass of the total amount of the hard coat layer constituent components.

Moreover, in the present invention, as modifying agents of the hard coat layer, a coating characteristic modifying agent, an antifoaming agent, a thickener, an antistatic agent, an organic lubricating agent, an organic polymer, an ultraviolet-ray absorbing agent, a photo-stabilizer, a dye, a pigment or a stabilizer may be used, and these are used as compound components of the coat layer forming the hard coat layer within such a range as not to impair reactions by active rays or heating, and improve the characteristics of the hard coat layer depending on the applications thereof.

Furthermore, the hard coat layer may contain metal compound particles (for example, antimony oxide particles containing tin (ATO), antimony oxide particles containing zinc, indium oxide particles containing tin (ITO), zinc oxide/ aluminum oxide particles, antimony oxide particles, and the like) so as to set the refractive index of the hard coat layer to 1.60.

In the present invention, as the method for curing the above-mentioned hard coat composition, for example, a method for irradiating the layer with ultraviolet rays as active rays and a method for using a high-temperature heating process may be used, and when these methods are used, a photopolymerization initiator, a thermopolymerization initiator, or the like is preferably added to the hard coating composition.

Specific examples of the photopolymerization initiator include: carbonyl compounds, such as acetophenone, 2,2-diethoxyacetophenone, p-dimethylacetophenone, p-dimethylaminopropiophenone, benzophenone, 2-chlorobenzophenone, 4,4'-dichlorobenzophenone, 4,4'-bisdiethyl aminobenzophenone, Michler's ketone, benzyl, benzoin, benzoin methyl ether, benzoin ethyl ether, benzoin isopropyl ether, methylbenzoyl formate, p-isopropyl-$\alpha$-hydroxyisobutyl phenone, $\alpha$-hydroxyisobutyl phenone, 2,2-dimethoxy-2-phenyl acetophenone, and 1-hydroxycyclohexylphenyl ketone; and sulfur compounds, such as tetramethylthiuram monosulfide, tetramethylthiuram disulfide, thioxanthone, 2-chlorothioxanthone, 2-methylthioxanthone, and the like. Each of these photopolymerization initiators may be used alone, or two or more kinds of these may be used in combination.

Moreover, as the thermopolymerization initiator, a peroxide compound, such as benzoyl peroxide and di-t-butyl peroxide, may be used.

The amount of use of the photopolymerization initiator or the thermopolymerization initiator is properly in a range from 0.01 to 10% by mass relative to 100% by mass of the total amount of the hard coat layer constituent components. In the case when electron rays or gamma rays are used as the curing means, the polymerization initiator is not necessarily required to be added. Moreover, in the case when the thermal curing process is carried out at a high temperature of 200°C or more, the addition of the thermopolymerization is not necessarily required.

The hard coat layer forming composition to be used in the present invention may preferably contain a leveling agent. With this structure, a recessed structure having many flat portions can be easily formed on the surface of the hard coat layer, and recesses capable of effectively exerting the reflection preventing characteristics and the recessed structure having a resin layer occupancy R in a range from 5% or more but less than 20% can be easily formed on the resin layer. Additionally, in the case when the recessed structure having many flat portions is formed on the surface of the hard coat layer, since the reflection preventing layer to be formed on the hard coat layer is generally an ultra-thin film, the recessed structure of the resin layer is allowed to follow the recessed structure of the hard coat layer.

As described above, in order to set the resin layer occupancy R of the filter for a display of the present invention to 5% or more but less than 20%, the following methods are particularly effective: (1) upon carrying out a coating process, to adjust the viscosity of the coating solution to an appropriate range, (2) to control the volume coated amount appropriately relative to the theoretical volume coated amount, (3) to appropriately adjust drying conditions, such as drying time and the like, and (4) to contain the leveling agent, and by appropriately combining these (1) to (4) methods to be used, the value of the resin layer occupancy R can be desirably controlled.

As the leveling agent, a silicone-based compound, a fluorine-based compound, an acryl-based compound and the like are exemplified. For example, as the silicone-based leveling agent, a compound that has polydimethyl siloxane as a basic skeleton to which a polyoxyalkylene group is added is preferably used, and a dimethylpolysiloxane-polyoxyalkylene copolymer (for example, SH190, available from Dow Corning Toray Co., Ltd.) is exemplified. Moreover, as the acryl-based compound, "ARUFON-UP1000 Series, UH2000 Series, UC3000 Series (trade names): available from Toagosei Co., Ltd." and the like are exemplified. Since the acryl-based compound has a number of alkyl chains and consequently has a characteristic that hardly impairs the coating property and adhesive property of the resin layer to be formed on the hard coat layer, the acryl-based compound is preferably used. The added amount of the leveling agent is preferably 0.01 to 5% by mass relative to 100% by mass of the total amount of the hard coat layer constituent components.

As the active rays to be used on demand in the present invention, electromagnetic waves that polymerize the acryl-based vinyl group, such as ultraviolet rays, electron beam and radioactive rays (such as $\alpha$ ray, $\beta$ ray, $\gamma$ ray, etc.) are exemplified, and in practice, ultraviolet rays are easily used and preferably selected. As the source of ultraviolet rays, examples thereof include: an ultraviolet fluorescent lamp, a low-pressure mercury lamp, a high-pressure mercury lamp, an ultra-high pressure mercury lamp, a xenon lamp, a carbon arc lamp, and the like. Moreover, when, upon irradiation with the active rays, the irradiation is applied under a low oxygen concentration, an effective curing process can be carried out. Moreover, in the case of the electron beam system, operations are required in an inert gas atmosphere by using expensive apparatuses; however, this method is advantageous because neither photopolymerization initiator nor photo-sensitizer has to be contained in the coat layer.

As the heating method required for the thermal curing process in the present invention, a method in which, by using a steam heater, an electric heater, an infrared ray heater, or a far infrared ray heater, air or inert gas, heated to have a temperature of at least 140°C or more, is blown to the base member and the coat film through a slit nozzle is proposed, and in particular, heat, derived from air heated to 200°C or more, is preferably used, and heat of nitrogen heated to 200°C or more, is more preferably used, because this makes the curing speed faster.

As the curing method of the hard coat layer, from the viewpoint of allowing the hard coat layer to have high hardness as well as from the view point of high productivity, the irradiation method with active rays is preferably used, and more preferably, the irradiation method with ultraviolet rays is used. Therefore, a hard coat layer of the ultraviolet-ray curing type is preferably used as the hard coat layer of the present invention.

Moreover, the hard coat layer may contain particles as described earlier. The detailed description has been given earlier.

(Reflection Preventing Layer)

The reflection preventing layer of the present invention, which has a reflection preventing film, is more specifically prepared as, for example, a layer that is formed as a single layer by laminating a thin film of a fluorine-based transparent polymer resin, or a magnesium fluoride- or silicon-based resin, or silicon oxide that has a low refractive index of 1.5 or less, more preferably 1.4 or less, with an optical film thickness of, for example, a 1/4 wavelength, and a layer that is formed as a multiple layered structure of two or more layers having different refractive indexes by laminating thin films of an inorganic compound, such as a metal oxide, a fluoride, a silicate, a nitride, and a sulfide, and an organic compound, such as a silicon-based resin, an acrylic resin, and a fluorine-based resin. In the present invention, a structure having only the low-refractive index layer as the reflection preventing layer, or a structure having both of a low-refractive index layer and a high-refractive index layer laminated thereon may be used. The reflection preventing layer is normally laminated on the hard coat layer. As described earlier, from the economic point of view, as well as from the viewpoint of controlling the surface recessed/protruding shape with high precision, a single layer is preferably used. That is, the reflection preventing layer of the present invention is preferably constructed by only the low-refractive index layer.

In the case when the balance between the costs and performances are taken into consideration, although not particularly limited, as the forming method for the reflection preventing layer, a coating method for applying a paint by a wet coating process is preferably used. As the coating method for the paint, methods, such as a micro-gravure coating method, a spin coating method, a dip coating method, a curtain flow coating method, a roll coating method, a spray coating method and a flow coating method, are preferably used; however, from the viewpoint of evenness of the coat thickness, the micro-gravure coating method is more preferably used. After the coating process, heating and drying processes are carried out, and a curing process is then carried out by heating or active rays, such as ultraviolet rays, so that various coat films can be formed.

In the case when a laminated body composed of, for example, a hard coat layer and a reflection preventive layer are used as the resin layer, the reflection preventing layer of the present invention is placed on the uppermost surface of the filer for a plasma display. For this reason, since it is undesirable to have scratches when dusts and the like adhered to the surface of the reflection preventing layer are wiped with a cloth, the aforementioned scratch resistant property, tested by the use of steel wool, is preferably set to class 3 or higher. More preferably, it is set to class 4 or higher.

The reflection preventing layer of the present invention is not particularly limited as long as it has a reflection preventing performance, and the following description will discuss a reflection preventing layer to be preferably used in the present invention.

The refractive index of the low refractive index layer is preferably in a range from 1.23 to 1.42, more preferably from 1.34 to 1.38. The refractive index of the high refractive index layer is preferably in a range from 1.55 to 1.80, more preferably from 1.60 to 1.75. In the case when the lamination structure of the high refractive index layer and the low refractive index layer is used as the reflection preventing layer, the difference of the refractive indexes of the low refractive index layer and the high refractive index layer is preferably 0.15 or more.

Moreover, the refractive index of the hard coat layer is also desirably adjusted. The refractive index of the hard coat layer is preferably 1.45 to 1.55. In the case when only the low refractive index layer is formed on the hard coat layer as the reflection preventing layer, the refractive index of the low refractive index layer is preferably a value lower than the refractive index of the hard coat layer by 0.15 or more.

In the reflection preventing layer of the present invention, as the constituent component of the high refractive index layer, a material formed by scattering metal compound particles in resin composition is preferably used so as to provide a static charge preventing characteristics to the surface of the reflection preventing layer. A (meth) acrylate compound is used as the resin component. The (meth)acrylate compound is preferable because it is radically polymerized by active light-ray irradiation so that the solvent resistant property and hardness of a film to be formed can be improved, and since a polyfunctional (meth) acrylate compound having two or more (meth) acryloyl groups in each molecule has improved solvent resistant property and the like, this compound is, in particular, preferably used in the present invention. Examples thereof include: trifunctional (meth)acrylates, such as pentaerythritol tri(meth)acrylate, trimethylolpropane tri (meth)acrylate, glycerol tri(meth)acrylate, ethylene-modified trimethylol propane tri(meth)acrylate, and tris-(2-hydroxyethyl)-isocyanurate tri(meth)acrylate; and tetra-functional or higher functional (meth) acrylates, such as pentaerythritol tetra (meth) acrylate, dipentaerythritol penta (meth) acrylate, and dipentaerythritol hexa(meth)acrylate.

As the metal compound particles to be used in this case, various kinds of conductive metal compound particles are preferably used. In particular, antimony oxide particles containing tin (ATO), antimony oxide particles containing zinc, indium oxide particles containing tin (ITO), zinc oxide/aluminum oxide particles, antimony oxide particles, and the like, are preferably used. More preferably, indium oxide particles containing tin (ITO) are used.

As the conductive metal compound particles having conductivity, those particles having an average primary particle size in a range from 0.005 to 0.05 μm are desirably used. When the average primary particle size exceeds 0.05 μm, the resultant coat film (high refractive index layer) tends to have degradation of transparency. In contrast, when the average primary particle size is less than 0.005 μm, the metal compound particles tend to easily aggregate to cause an increase in the haze value of the generated coat film (high refractive index layer). In both of these cases, it becomes difficult to obtain a desired haze value. Moreover, in the case when a laminated structure of the hard coat layer and the reflection preventing layer is used as the resin layer (with the hard coat layer being placed on the conductive layer side), as well as in the case when, by controlling Ra of the hard coat layer, an attempt is made to control the Ra of the resin layer, the addition of large particles having a particle size exceeding 0.05 μm in the average primary particle size to the high refractive index layer of the reflection preventing layer causes the Ra value of the outermost surface of the resin layer to fail to follow the Ra value of the hard coat layer, with the result that the particles of the reflection preventing layer tend to give influences to the Ra of the outermost surface of the resin layer. The primary particle size refers to a particle size in stand-still state measured by an electron microscope, or an adsorption method by using a gas or a solute, an air circulation method, an X-ray small angle scattering method, and the like.

The compounding ratio of the constituent components of the high refractive index layer is preferably 10/90 to 30/70, more preferably 15/85 to 25/75, in the mass ratio [(A)/(B)] between the resin components (A) and the metal compound particles (B). In the case when the metal compound particles are set within this preferable range, the resultant film has sufficient transparency and good conductivity, causing no degradation in various physical and chemical strengths of the resultant film.

The high refractive index layer is preferably formed by processes in which a coating solution with ingredients dispersed by a solvent is prepared and after the coating solution has been applied onto a hard coat layer, the resultant layer is subjected to drying and curing processes.

Moreover, as the amount of the organic solvent, a preferable amount thereof may be used so as to allow the composition to have a desirable viscosity for workability in accordance with the applying means and printing means, and it is normally set so as to make the solid component concentration of the composition to 60% by mass or less, more preferably to 50% by mass or less.

As one preferred mode of the reflection preventing layer in the present invention, the low refractive index layer is prepared as a layer coated with a paint composition containing silica fine particles having voids therein, a siloxane compound, a curing agent and a solvent so that the refractive index is desirably made lower and the surface reflectance is also desirably made lower.

As one preferred mode, the low refractive index layer is preferably prepared as a layer in which a siloxane compound serving as a matrix material and silica fine particles are firmly joined to each other so as to improve the surface hardness with superior scratch resistant characteristics, and for this purpose, the siloxane compound is preferably allowed to preliminarily react with the silica fine particle surface in a stage of the paint composition prior to the coating process, so as to be joined to each other.

The paint composition to be used for this purpose can be obtained by processes in which, after a silane compound has been hydrolyzed in a solvent by an acid catalyst in the presence of silica fine particles so that a silanol compound has been formed, the resultant silanol compound is subjected to a condensation reaction.

As the silane compound for use in forming the silanol compound, the following fluorine-containing silane compounds and silane compounds (containing no fluorine) are exemplified.

Examples of the fluorine-containing silane compounds include: trifluoromethyl trimethoxy silane, trifluoromethyl triethoxy silane, trifluoropropyl trimethoxy silane, trifluoropropyl triethoxy silane, and the like.

Moreover, examples of the silane compound (containing no fluorine) include: vinyl trialkoxy silane, 3-methacryloxypropyl trialkoxy silane, methyl trimethoxy silane, methyl triethoxy silane, phenyl trimethoxy silane, phenyl triethoxy silane, dimethyl dialkoxy silane, tetramethoxy silane, tetraethoxy silane, and the like.

Each of these silane compounds may be used alone, or two or more kinds of these may be used in combination.

In the case when a coat film is formed as the low refractive index layer, the content of the siloxane compound is preferably 20 to 70% by mass, more preferably to 30 to 60% by mass, relative to 100% by mass of the total components of the low refractive index layer. By containing the siloxane compound in this range, the refractive index of the low refractive index layer is desirably made lower and the hardness of the coat film of the low refractive index layer is desirably increased. Therefore, the content of the siloxane compound in the paint is preferably set in the above-mentioned range, relative to the total components except for the solvent.

Among these, in order to achieve a low refractive index, the fluorine-containing silane compound is preferably used as an essential component, with one or more kinds of silane compounds selected from the silane compounds being used in combination. The content of the fluorine-containing silane compound is preferably 20 to 80% by mass, more preferably 30 to 60% by mass, relative to 100% by mass of the amount of the total silane compounds. When the amount of the fluorine-containing silane compound is smaller than 20% by mass, the reduction of the refractive index tends to be insufficient. In contrast, when the amount of the fluorine-containing silane compound exceeds 80% by mass, the hardness of the coat film sometimes tends to be lowered.

As the silica fine particles to be used for the low refractive index layer, those particles having a number average particle size of 1 nm to 50 nm are desirably used. When the number average particle size is smaller than 1 nm, the bonding to the matrix material becomes insufficient, resulting in a reduction in the hardness of the coat film in some cases. In contrast, when the number average particle size exceeds 50 nm, the generation of voids among the particles, which is caused by introduction of a large number of particles, becomes smaller, failing to sufficiently exert the effect for reducing the low refractive index in some cases. In this case, the average particle size of the silica fine particles can be measured by using any one of various particle counters. The particle size of the silica fine particles is preferably measured prior to the addition thereof to the paint. Moreover, after the formation of the coat film, the particle size of the silica fine particles in the coat film is desirably measured by using an electron scanning microscope or a transmission electron microscope. A measuring process that uses a transmission electron microscope as the number average particle size measuring method is exemplified in which a sample, prepared by using an ultra-thin film cutting method, is observed under the transmission electron microscope (Type H-7100 FA manufactured by Hitachi, Ltd.) at an acceleration voltage of 100 kV (magnification: about 100,000 times) so that the average particle size can be found from the resulting image.

Moreover, in the case when a laminated structure of the hard coat layer and the reflection preventing layer is used as the resin layer (with the hard coat layer being placed on the conductive layer side), as well as in the case when, by controlling Ra of the hard coat layer, an attempt is made to control the Ra of the resin layer, the addition of large particles having a particle size exceeding 50 nm in the average primary particle size to the low refractive index layer of the reflection preventing layer causes the Ra value of the outermost surface of the resin layer to fail to follow the Ra value of the hard coat layer, with the result that the particles of the reflection preventing layer tend to give influences to the Ra of the outermost surface of the resin layer.

The number average particle size of silica fine particles to be used for the low refractive index layer is preferably made to be smaller than the film thickness of the coat film to be formed. When it becomes larger than the film thickness of the coat film, the silica fine particles are exposed to the surface of the coat film, impairing the reflection preventing characteristics, as well as causing a reduction in the surface hardness and contamination resistant characteristics of the coat film.

As the silica fine particles to be used in the low refractive index layer, silica fine particles having a silanol group on the surface thereof are preferably used so as to easily react with the siloxane compound of the matrix. Moreover, in order to reduce the refractive index of the coat film, silica fine particles having voids inside thereof are preferably used. Since the silica fine particles having no voids inside thereof generally have a refractive index of their own in a range from 1.45 to 1.50, their refractive index reducing effect is small. In contrast, since the silica fine particles having voids inside thereof have a refractive index of their own in a range from 1.20 to 1.40, their refractive index reducing effect becomes larger when introduced therein. As the silica fine particles having voids inside thereof, silica fine particles having void portions surrounded by outer cores, porous silica fine particles having a number of void portions, and the like are exemplified.

The content of the silica fine particles to be used in the low refractive index layer is preferably in a range from 30 to 80% by mass, more preferably from 40 to 70% by mass, relative to 100% by mass of the total amount of the constituent components of the low refractive index layer, when the coat film is formed as the low refractive index layer. Therefore, the content of the silica fine particles in the paint composition is preferably set in the above-mentioned range relative to the total components except for the solvent. When the silica fine particles are contained in the coat film within this range, it becomes possible not only to reduce the refractive index, but also to increase the hardness of the coat film. When the content of the silica fine particles is smaller than 30% by mass, the refractive index reducing effect derived from the voids among the particles is reduced. Moreover, when the content of the silica fine particles exceeds 80% by mass, many island phenomena occur in the coating film, resulting in a reduction in the hardness of the coat film and unevenness in refractive index, depending on places; therefore, this structure is not preferable.

Moreover, the paint composition for use in forming the low refractive index layer, as described above, can be obtained from processes in which, after a silane compound has been hydrolyzed in a solvent by an acid catalyst in the presence of silica fine particles so that a silanol compound has been formed, the resultant silanol compound is then subjected to a condensation reaction, and in the hydrolyzing reaction, after adding the acid catalyst and water to the solvent in 1 to 180 minutes, the reaction is preferably carried out in a range from room temperature to 80°C for 1 to 180 minutes. By carrying out the hydrolyzing reaction under these conditions, it is possible to suppress an abrupt reaction. The reaction temperature is more preferably set to 40 to 70°C. After the silanol compound has been obtained by the hydrolyzing reaction, the reaction solution, as it is, is preferably heated in a temperature range from 50°C or more to a boiling temperature or less of the solvent for 1 to 100 hours so as to be subj ected to a condensation reaction. Moreover, in order to increase the polymerization degree of the siloxane compound, a reheating process or an addition of a basic catalyst may also be carried out.

As the acid catalyst to be used for the hydrolyzing reaction, for example, hydrochloric acid, acetic acid, formic acid, nitric acid, hydrochloric acid, sulfuric acid, phosphoric acid, polyphosphoric acid, polyhydric carboxylic acid or anhydrides thereof, and acid catalysts such as ion exchanged resins may be proposed. In particular, an acidic aqueous solution using formic acid, acetic acid or phosphoric acid is preferably used. As the preferable added amount of these acidic catalysts, it is preferably n a range from 0.05 to 10% by mass, more preferably from 0.1 to 5% by mass, relative to the total amount of the silane compound to be used during the hydrolyzing reaction. When the amount of the acidic catalyst becomes smaller than 0.05% by mass, the hydrolyzing reaction sometimes fails to proceed sufficiently, while in the case when the amount of the acidic catalyst exceeds 10% by mass, the hydrolyzing reaction might excessively progress.

Although not particularly limited, the solvent is determined by taking the stability, wettability, volatility and the like of the paint composition into consideration. Not limited to one kind, two or more kinds of solvents may be used as a mixture. Specific examples of the solvent include: alcohols, such as methanol, ethanol, propanol, isopropanol and butanol; glycols, such as ethylene glycol and propylene glycol; ethers, such as ethylene glycol monomethyl ether and ethylene glycol monoethylether; and ketones, such as methylethyl ketone and methylisobutyl ketone.

The amount of the solvent to be used upon carrying out the hydrolyzing reaction is preferably in a range from 50 to 500% by mass, more preferably from 80 to 200% by mass, relative to 100% by mass of the total amount of the silane compound. In the case when the amount of the solvent is smaller than 50% by mass, the reaction might excessively progress, resulting in a gelation in some cases. In contrast, when the amount of the solvent exceeds 500% by mass, the hydrolyzing process might fail to progress in some cases.

Moreover, as the water to be used for the hydrolyzing reaction, ion-exchange water is preferably used. The amount of water can be desirably selected, and relative to one mol of the silane compound, it is preferably used in a range from 1.0 to 4.0 mol.

Furthermore, in order to cure the paint composition thus coated to form the low refractive index layer, a curing agent may be contained therein. As such a curing agent, various kinds of curing agents or three-dimensional cross-linking agents that accelerate the curing process of the paint composition, or make the curing process easier, are exemplified. Specific examples of the curing agent include a nitrogen-containing organic substance, a silicone resin curing agent, various metal alcoholates, various metal chelate compounds, isocyanate compounds and polymers thereof, melamine resin, polyfunctional acrylic resin, urea resin and the like, and one kind of these or two or more kinds of these may be added thereto. Among these, from the viewpoints of stability of the curing agent and processability of the resulting coat film, metal chelate compounds are preferably used. As the metal chelate compound to be used, a titanium chelate compound, a zirconium chelate compound, an aluminum chelate compound and a magnesium chelate compound are exemplified. Among these, in order to reduce the refractive index, the aluminum chelate compound and/ormagnesium chelate compound, which have a low refractive index, are preferably used. These chelate compounds can be easily obtained by allowing a metal alkoxide to react with a chelating agent. As the chelating agent, for example, aluminum tris(acetylacetonate) and aluminum tris(acetylacetate) are exemplified. The amount of the curing agent to be added is preferably 0.1 to 10% by mass, more preferably 1 to 6% by mass, relative to 100% by mass of the total amount of the silane compounds in the paint composition. In this case, the total amount of the silane compounds refers to an amount that includes all the silane compounds, hydrolyzed products and condensates thereof. When the content of the curing agent is smaller than 0.1% by mass, the hardness of the resultant coat film is lowered. In contrast, in the case when the content of the curing agent exceeds 10% by mass, although the hardness becomes sufficient to improve the hardness of the resultant coat film, the refractive index also becomes higher disadvantageously. The content of all the solvents in the paint composition is preferably in a range from 1300 to 9900% by mass, more preferably from 1500 to 6000% by mass, relative to 100% by mass of the content of all the silane compounds. When the content of all the solvents is smaller than 1300% by mass or the content of all the solvents exceeds 9900% by mass, it becomes difficult to form a coat film having a predetermined film thickness. In this case, the total amount of the silane compounds refers to an amount that includes all the silane compounds, hydrolyzed products and condensates thereof.

As another mode of the low refractive index layer in the present invention, an active ray-curing type low refractive index layer containing fluorine-containing compound and/or the aforementioned silica-based fine particles having voids inside thereof is exemplified. The low refractive index layer of the active ray-curing type means that an active ray-curing type resin is contained therein.

As the fluorine-containing compound, fluorine-containing monomers and fluorine-containing polymers are exemplified.

Examples of the fluorine-containing monomer include: fluorine- containing (meth)acrylic esters, such as 2,2,2-trifluoroethyl (meth)acrylate, 2,2,3,3,3-pentafluoropropyl (meth) acrylate, 2-(perfluorobutyl)ethyl (meth)acrylate, 2-(perfluorohexyl)ethyl (meth)acrylate, 2-(perfluorooctyl)ethyl (meth)acrylate, and 2-(perfluorodecyl)ethyl (meth)acrylate.

As the fluorine-containing polymer, for example, a fluorine-containing copolymer containing a monomer for use in applying a crosslinking group to the fluorine-containingmonomer as its structural unit is exemplified. Specific examples of the fluorine-containing monomer unit include: fluoroolefines (for example, fluoroethylene, vinylidene fluoride, tetrafluoroethylene, hexafluoroethylene, hexafluoropropylene, perfluoro-2,2-dimethyl-1,3-dioxole, etc.), partially or completely fluoridated alkyl ester derivatives of (meth) acrylic acids (for example, Viscoat 6FM (available from Osaka Organic Chemical Industry Ltd.) and M-2020 (available from from Daikin Industries, Ltd.), etc.), completely or partially fluoridated vinyl esters, and the like. Examples of the monomer for use in applying a crosslinking group include: in addition to (meth) acrylate monomers preliminarily including a crosslinkable functional group in the molecule, such as glycidyl methacrylate, and (meth)acrylate monomers having groups, such as a carboxyl group, a hydroxyl group, an amino group, a sulfonic acid group, and the like (for example, (meth)acrylic acid, methylol (meth)acrylate, hydroxyalkyl (meth)acrylate, allylacrylate, etc.).

The active-ray curing type resin refers to a resin that is polymerized and cured upon irradiation with active rays, and acryl-based resins are preferably used as such a resin. The active rays represent ultraviolet rays, electron beam and radioactive rays (such as $\alpha$ ray, $\beta$ ray, $\gamma$ ray, etc.), and the like, and in practice, electron beam and ultraviolet rays are preferable, and in particular, ultraviolet rays are easily used and preferably selected. Examples of the source of ultraviolet rays include: an ultraviolet fluorescent lamp, a low-pressure mercury lamp, a high-pressure mercury lamp, an ultra-high pressure mercury lamp, a xenon lamp, a carbon arc lamp, and the like. Moreover, when, upon irradiation with the active rays, the irradiation is applied under a low oxygen concentration, an effective curing process can be carried out. Moreover, in the case of the electron beam system, operations are required in an inert gas atmosphere by using expensive apparatuses; howeyer, this method is advantageous because neither photopolymerization initiator nor photosensitizer has to be contained in the paint composition.

As the above-mentioned active-ray curing type resin, a polyfunctional (meth)acrylate compound having two or more (meth)acryloyl groups in the molecule is preferably used. Moreover, a polyfunctional (meth) acrylate compound having three or more (meth) acryloyl groups in the molecule is more preferably used, and in particular, a polyfunctional (meth)acrylate compound having 3 to 10 acryloyl groups in the molecule is most preferably used.

Examples of the polyfunctional (meth)acrylate compound include: ethylene glycol di(meth)acrylate, dicyclopentenyl di(meth)acrylate, triethylene glycoldiacrylate, tetraethylene glycol di(meth)acrylate, tricyclodecane diyl-dimethylene di(meth)acrylate, tris(2-hydroxyethyl) isocyanurate di(meth)acrylate, tripropylene glycol di(meth)acrylate, neopentyl glycol di (meth) acrylate, bisphenol A diglycidyl ether with (meth)acrylate adducts located at both terminals, 1,4-butanediol di(meth)acrylate, 1,6-hexanediol (meth)acrylate, pentaerythritol tri(meth)acrylate, trimethylolpropane tri(meth)acrylate, glycerol tri(meth)acrylate, ethylene-modified trimethylolpropane tri(meth)acrylate, tris-(2-hydroxyethyl)-isocyanurate tri (meth)acrylate, pentaerythritol tetra(meth)acrylate, dipentaerythritol penta(meth) acrylate, dipentaerythritol hexa(meth) acrylate, and the like. In the present invention, the term "...(meth)acryl..." represents an abbreviation of "...acryl..., or ...methacryl...".

Among the above-mentioned polyfunctional (meth) acrylate compounds, polyfunctional (meth)acrylate compounds having three or more (meth)acryloyl groups in the molecule are preferably used, and in particular, polyfunctional (meth) acrylate compounds having 3 to 10 acryloyl groups in the molecule are more preferably used.

In order to accelerate the polymerizing and curing processes of the polyfunctional (meth)acrylate compound, a photopolymerization initiator is preferably contained therein. As the photopolymerization initiator, the same compounds as those used in the hard coat layer can be used.

In the present invention, in the case when the resin layer includes the reflection preventing layer, by allowing the reflection preventing layer to contain particles having an appropriate particle size, the Ra of the resin layer outermost surface can be controlled. In this case, however, the particles, which are contained in the reflection preventing layer so as to improve the surface hardness and scratch preventing characteristics in the low refractive index layer, are added thereto so as to improve the static charge preventing characteristics in the case of the high refractive index layer; therefore, various particles to be used for the reflection preventing layer are preferably made to have a very small particle size. In the case when such particles having a very small particle size are used for the reflection preventing layer, in an attempt to control the Ra of the resin layer outermost surface by controlling the Ra of the hard coat layer, with the laminated structure of the hard coat layer and the reflection preventing layer being used as the resin layer (with the hard coat layer being placed on the conductive layer side), the particles to be used for the reflection preventing layer do not give influences to the center-line average roughness Ra of the resin layer.

(Other Functional Layers)

The filter for a display of the present invention is preferably provided with a functional layer having at least one function selected from the group consisting of a near infrared-ray blocking function, a color-tone correcting function, an ultraviolet-ray blocking function and an Ne-cutting function. This functional layer may be prepared as one layer having a plurality of functions. Moreover, the functional layer may be prepared as a laminated structure including a plurality of layers.

The following description will discuss functional layers included in the filter for a display of the present invention.

(Color-tone correcting Layer)

The color-tone correcting layer, which is one kind of functional layers, and has a color-tone correcting function, contains coloring matters having color-tone correcting functions, and carries out a color tone correction on transmission visible light so as to improve image characteristics of the display panel, that is, more specifically, to provide high contrast and highly visible colors. Moreover, the color-tone correcting layer makes it possible to adjust the transmittance of the entire filter for a display, and also has a function for adjusting a reflection preventing function.

The color tone correction is achieved by selectively absorbing visible light rays of specific wavelengths among visible light rays that are transmitted through the filter for a display. Therefore, the coloring matter to be contained in the color-tone correcting layer is used for selectively absorbing visible light rays having specific wavelengths, and either dye or pigment may be used as the coloring matter. The expression "selectively absorbs visible light rays having specific wavelengths" means that among light rays in a wavelength range (wavelengths of 380 to 780 nm) of visible light rays, light rays in a specific wavelength range are peculiarly absorbed. In this case, the wavelength range to be peculiarly absorbed by the coloring matter may be a single wavelength range or a plurality of wavelength ranges.

Examples of the coloring matter for absorbing a specific wavelength include: conventionally known organic pigments and organic dyes, and inorganic pigments, such as azo-based, condensed azo-based, phthalocyanine-based, anthraquinone-based, indigo-based, perinone-based, perylene-based, dioxazine-based, quinacridone-based, methine-based, isoindolinone-based, quinophthalone-based, pyrrole-based, thioindigo-based, and metal complex-based pigments and dyes.

The color-tone correcting layer may have various modes as long as it contains a coloring matter having a color-tone correcting capability. The color-tone correcting layer may be formed by using a preferable method in accordance with the applied mode. For example, in the case of a mode in which a coloring matter having a color-tone correcting function is contained in a sticker, a coloring matter having a color-tone correcting function is added to the sticker as a dye or a pigment so that this is applied to form a color-tone correcting layer having a desired thickness.

In the case of a mode in which a transparent base member or a transparent substrate is subjected to a coloring process so that the color-tone correcting layer is formed, a coloring matter having a color-tone correcting function, as it is, is used as a dye or a pigment, or dissolved in a solvent, and this is applied and dried so that a color-tone correcting layer having a desired thickness can be formed.

Moreover, in the case when the color-tone correcting layer is a transparent base member containing a coloring matter having a color-tone correcting function, a thermoplastic resin forming a material for the transparent base member is dissolved in a desired solvent, and to this is added the coloring matter having a color-tone correcting function to prepare a solution; thus, the resulting solution is applied and dried so that a color-tone correcting layer having a desired thickness can be formed.

(Near Infrared-Ray Blocking Layer)

The following description will discuss a near infrared-ray blocking layer having a near infrared-ray blocking function. In the case of a plasma display, since near infrared rays having an intensity in a level generated by the panel give influences to peripheral electronic apparatuses, such as a remote controller, a cordless telephone and the like, to cause an erroneous operation; therefore, the light rays in the infrared range need to be cut to a level that causes no problems in practical use. The problematic wavelength range is 800 to 1000 nm so that the transmittance in the corresponding wavelength range needs to be cut to 20% or less, preferably to 10% or less. In order to block the near infrared rays, the near infrared-ray blocking layer needs to contain a coloring matter normally having an near infrared-ray absorbing capability with a maximum absorbing wavelength in a range from 750 to 1100 nm; that is, specific preferable examples thereof include: polymethine-based, phthalocyanine-based, naphthol cyanine-based, metal complex-based, aluminum-based, immonium-based, diimmonium-based, anthraquinone-based, dithiol metal-complex based, naphthoquinone-based, indol phenol-based, azo-based, and triallylmethane-based compounds, and among these, metal-complex based, aluminum-based, phthalocyanine-based, naphthalocyanine-based, diimmonium-based compounds are more preferably used. Additionally, in the case when a coloring matter having a near infrared-ray absorbing function is used, one kind of these may be contained, or two or more kinds of these may be contained.

With respect to the structure, forming method, thickness and the like of the near infrared-ray absorbing layer, those that are the same as those of the color-tone correcting layer may be used. As the near infrared-ray absorbing layer, the same layer as the color-tone correcting layer, that is, the color-tone correcting layer to which a coloring matter having a color-tone correcting function and a coloring matter having a near infrared-ray absorbing function are contained, may be used, or another near infrared-rayblocking layer different from the color tone correcting layer may be used.

(Ne-cutting Layer)

Next, the following description will discuss a functional layer having an Ne-cutting function, which is one kind of the functional layers. To the near infrared-ray blocking layer or the color-tone correcting layer, one kind or a plurality of kinds of color-tone correcting agents, which are used for selectively absorbing excessive light emission colors (mainly in a wave-length range of 560 to 610 nm) from a discharge gas, for example, a two-component gas of neon and xenon, sealed in a plasma display panel, are preferably added in a mixed manner. With this coloring-matter arrangement, among visible light rays emitted from the display screen of the plasma display panel, excessive light rays derived from light emission of the discharge gas are absorbed and attenuated, with the result that display colors of the visible light rays, emitted from the plasma display panel, can be made closer to display colors of the display targets, thereby making it possible to display natural color tones.

(Ultraviolet Ray Blocking Layer)

Next, the following description will discuss an ultraviolet-ray blocking layer having an ultraviolet-ray blocking function. In the filter for a display of the present invention, the ultraviolet-ray blocking layer has a function for preventing photo-degradation of the coloring matter contained in the color-tone correcting layer, the infrared-ray blocking layer and the like that are located on the panel side from the ultraviolet-ray blocking layer. A transparent base member, a sticker layer or the like containing an ultraviolet-ray absorbing agent is used as the ultraviolet-ray blocking layer.

Examples of the ultraviolet-ray absorbing agent include a salicylic acid-based compound, a benzophenone-based compound, a benzotriazole-based compound, a cyanoacrylate-based compound, a benzoxazinone-based compound and a cyclic imino ester-based compound, and among these, from the viewpoints of ultraviolet-ray blocking characteristics in 380 to 390 nm, and color tones, the benzoxazinone-based compound is most preferably used. One kind of these compounds may be used alone, or two or more kinds of these may be used in combination. Moreover, it is more preferable to use a stabilizer, such as HALS (hindered amine-based photostabilizer) and an oxidation preventing agent, in combination.

The ultraviolet-ray blocking layer is preferably set to have a transmittance of 5% or less in a wavelength of 380 nm, and this structure makes it possible to protect the base member and the dye pigment from ultraviolet-rays.

The content of the ultraviolet-ray absorbing agent in the ultraviolet-ray blocking layer is preferably 0.1 to 5% by mass, more preferably 0.2 to 3% by mass. In the case when the content of the ultraviolet-ray absorbing agent is in a range from 0.1 to 5% by mass, superior effects for absorbing ultraviolet rays that are made incident from the viewer's side of the filter for a display and for preventing photo-degradation of the coloring matter contained in the color-tone correcting layer can be obtained, and the intensity of the transparent base member or the sticker layer is not impaired.

(Adhesive Layer)

In the present invention, in order to bond the aforementioned various functional layers to one another, or in order to bond the filter for a display to the display, an adhesive layer having adhesive characteristics may be used. In this case, as the sticker to be used, not particularly limited as long as it serves as an adhesive that bonds two objects to each other by its sticking function, an adhesive made from a rubber-based, acryl-based, a silicon-based or a polyvinyl-ether-based material may be used.

The sticker is generally classified into two types, that is, a solvent-type sticker and a non-solvent-type sticker. The solvent-type sticker, which is superior in drying property, productivity, and processability, has been still mainly used; however, in recent years, a shift to the non-solvent-type sticker has been gradually made from the viewpoints of pollution, energy conservation, stability, etc. Among these, an active-ray curing-type sticker, which can carry out a curing process in a unit of seconds by irradiation with active rays, and serves as a sticker having superior characteristics in flexibility, adhesiveness, chemical resistant, and the like, is more preferably used.

(Transparent Base Member)

The transparent base member of the present invention is normally used as a base member on which a reflection preventing layer, a hard coat layer, an infrared-ray cutting layer, a conductive layer and the like are laminated. Moreover, by adding an ultraviolet-ray absorbing component thereto, this member may serve as an ultraviolet-ray cutting layer.

In the present invention, the transparent base member is a film that can be film-formed by a fusing process, or film-formed by using a solution. Specific examples thereof include films made from polyester, polyolefin, polyamide, polyphenylene sulfide, cellulose ester, polycarbonate, acrylate, etc. These films are desirably used as base members for various functional layers in the present invention. However, in particular, polyester is desirably used because it exerts balanced performances in all the various characteristics, and is applied to base members for all the functional layers of the present invention.

Examples of such polyesters include: polyethylene terephthalate, polyethylene naphthalate, polypropylene terephthalate, polybutylene terephthalate and polypropylene naphthalate, and among these, polyethylene terephthalate is most preferable from the viewpoints of performances and costs.

The transparent base member to be used in the present invention may be a composite film having a laminated structure of two or more layers.

The thickness of the transparent base member in the present invention is properly selected on demand in accordance with the applications thereof, and from the viewpoints of mechanical strength and handling characteristics, it is preferably from 10 to 500 $\mu$m, more preferably from 20 to 300 $\mu$m.

The transparent base member of the present invention may contain various additives, resin compositions, crosslinking agents, and the like, within such a range as not to impair the effects of the present invention, in particular, the optical characteristics. Examples thereof include: an oxidation inhibitor, a heat resistant stabilizer, an ultraviolet-ray absorbing agent, organic and inorganic particles, pigments, dyes, an antistatic agent, a core agent, and the like.

The transparent base member to be used in the present invention preferably has the total light transmittance of 90% or more, and a haze value of 1.5% or less, and by using the base member of this type, it becomes possible to improve the visibility and definition of the image.

With respect to the transparent base member to be used in the present invention, a primer layer (easily bondable layer, under coating layer), used for strengthening the adhesion (adhesive strength) to the conductive layer and the aforementioned functional layers, is desirably formed thereon.

(Transparent Substrate)

The transparent substrate of the present invention, which imparts mechanical strength to the display panel main body, is formed by using an inorganic compound molded product and a transparent organic polymer molded product. As the inorganic compound molded product, preferably glass, reinforced or semi-reinforced glass, or the like, is exemplified, and the thickness is normally in a range from 0.1 to 10 mm, more preferably from 1 to 4 mm. In the present invention, by using glass serving as the transparent substrate, the mechanical strength is obtained; however, even in the case when glass is not used, since an air gap formed together with the plasma display panel is eliminated to provide an advantage, such as elimination of double reflection, the transparent substrate is not necessarily required to be used in the present invention.

Additionally, as the laminated layer structure of the filter for a display of the present invention, for example, structures, such as resin layer/conductive layer/transparent base member/colored sticker layer, resin layer/conductive layer/transparent base member/colored sticker layer/transparent substrate, resin layer/conductive layer/transparent base member/colored layer/sticker layer, and resin layer/conductive layer/transparent base member/colored layer/sticker layer/transparent substrate, are exemplified. In this case, the colored sticker layer and colored layer refer to layers that contain coloringmatters, such as a coloringmatter having a color-tone correcting function, a near infrared-ray absorbing coloring matter, and an Ne-cutting coloring matter.

EXAMPLES

The following description will discuss the present invention in detail by means of examples; however, the present invention is not intended to be limited to these.

(Evaluation Method)

(1) Measurement of resin layer occupancy R

By using a laser microscope VK-9700 (manufactured by KEYENCE Corporation), measurements were carried out at arbitrary 10 points of a sheet of a sample having a size of 20 cm $\times$ 20 cm, and an average value thereof was found. First, the sample was cut into pieces, each having a size of 1 cm $\times$ 1 cm, and the surface of the sample on the resin layer side is sputtered with platinum by using an ion coater. The conditions of the sputtering were: degree of vacuum: 13.3 Pa, electric current value: 2 mA, and sputtering time: 15 minutes. Next, three-dimensional image data of the sample on the resin layer side were measured by using software VK-H1V1 (observation-measuring software). At this time, three-dimensional image data of the resin layer between the center of gravity of one opening section of the conductive mesh and the center of gravity of the adjacent opening section were picked up. Next, the three-dimensional image data obtained as described above were two-dimensionally analyzed in the vertical direction by using analyzing software VK-H1A1 so that a two-dimensional profile was found. First, image noise of the three-dimensional image data was automatically eliminated, and in the case when, for example, the object was tilted upon measurement, the tilt was corrected. Thereafter, based upon a cross section including the center of gravity of the opening section and the center of gravity of the adjacent opening section, the profile was displayed by using straight lines passing through point A, point B and point C. From this profile, the height of point C from the straight line AB was measured so that the area α of a triangle ABC was calculated (the length of straight line AB is equal to the pitch of the conductive mesh). With respect to a method for finding the center of gravity of the opening section, for example, three-dimensional image data (plan view) were displayed on the screen, or the drawings of an opening section and an opening section adjacent thereto were copied onto a transparent sheet so that centers of gravity were determined by using a mathematical method, and the transparent sheet by which the centers of gravity have been determined are pasted onto the screen so as to determine centers of gravity on an analysis screen. Moreover, when the gap between point A and point B was selected as a section, the area β of the resin layer located inside the triangle ABC was calculated. Based upon the resulting area α of the triangle ABC and the area β of the resin layer located inside the triangle ABC, a resin layer occupancy R was calculated from the following equation:

$$R = (\beta/\alpha) \times 100.$$

(2) Measurement of Center-Line Average Roughness Ra

The center-line average roughness Ra of the sample on the resin layer side was measured by using a surface roughness measuring instrument SE-3400 (manufactured by Kosaka Laboratory Ltd.). Measurements were carried out on arbitrary 5 points of a sheet of sample having a size of 20 cm × 20 cm, and the average value thereof was defined as a value of Ra of the resin layer of the sample of a filter for a display. Additionally, at the time of the measurement, a member, formed by pasting the sample on the sticker layer side onto a glass plate having a thickness of 2 . 5 mm, was used. Moreover, upon carrying out the measurement, the shifting direction of a measuring needle was set in parallel with thin lines of the conductive mesh, with the shifting direction being also allowed to pass through virtually the center of the non-protruding area (opening section) of the conductive mesh, so that five of measured values in which the pitch of the waveform obtained by the measurement appeared virtually in the same manner as the pitch of the conductive mesh were taken, and averaged.

• Measuring Conditions:

Feeding rate: 0.5 mm/s
Cut-off value λc:
In the case of Ra of 20 nm or less: λc = 0.08 mm
In the case of Ra from 20 or more to 100 nm or less:
λc = 0.25 mm
In the case of Ra from 100 nm or more to 2000 nm or less:
λc = 0.8 mm
Evaluation length: 8 mm

Additionally, upon measuring under the above-mentioned measuring conditions, first, measurements were carried out at a cut-off value λc = 0.8 mm, and as a result, when Ra was greater than 100 nm, the Ra was adopted. In contrast, in the case when, as a result of the above-mentioned measurements, Ra was 100 nm or less, measurements were again carried out at a cut-off value λc = 0.25 mm, and as a result of the re-measurements, when Ra was 20 nm or more, the Ra was adopted. In contrast, as a result of the re-measurements, when Ra was 20 nm or less, measurements were carried out at a cut-off value λc = 0.08 mm, and the Ra was adopted. • Ra: parameter defined as Ra by the surface roughness measuring instrument SE-3400 (manufactured by Kosaka Laboratory Ltd.), measured based upon the method of JIS B0601-1982.

(3) Depth D of Recess of Resin Layer

The depth D of a recess of the resin layer was measured by using a laser microscope VK-9700 (manufactured by KEYENCE Corporation). Measurements were carried out at arbitrary 10 points of a sheet of a sample having a size of 20 cm × 20 cm, and an average value thereof was defined as the depth D of the recess of the sample. In the measuring method, first, by using observation-measuring software VK-H1V1, a sample having a size of 5 cm × 5 cm was set so that the upper side and lower side of the opening section of the conductive mesh were made in parallel with the screen. The magnification was adjusted so that at least one opening section of the conductive mesh was included. After the measuring height range had been set by adjusting the focal point, measurements were carried out. Next, the measured data were analyzed by using analyzing software VK-H1A1. First, image noise of the measured data was automatically eliminated, and in the case when, for example, the object was tilted upon measurement, the tilt was corrected. Thereafter, line roughness was measured. At this time, the analysis was carried out on a straight line in parallel with the screen including at least one opening section of the conductive mesh. Various corrections (height smoothing → ± 12 simple average, tilt correction → straight line (automatically carried out)) were carried out so that a waving curve was calculated by using a cut-off value $\lambda c = 0.08$ mm, without $\lambda s$ and $\lambda f$; thus, the maximum height $W_z$ calculated based upon the standard of JIS B0633-2001 was defined as the depth D of a recess of the resin layer. Additionally, a member, formed by pasting the sample on the sticker layer side onto a glass plate having a thickness of 2.5 mm, was used as the sample.

(4) Thickness of Conductive Mesh

A cross section of a sample was cut out by using a microtome, and the cross section was observed by an electrolytic emission scanning electron microscope (S-800, manufactured by Hitachi, Ltd., acceleration voltage: 26 kV, observation magnification: 3000 times) so that the thickness of the conductive mesh was measured. The measurements were carried out at arbitrary 5 points of one sample having a size of 20 cm × 20 cm, and the average value was defined as a thickness of the conductive mesh.

(5) Line Width and Pitch of Conductive Mesh

By using a digital microscope (VHX-200) manufactured by KEYENCE Corporation, the surface observation was carried out in a magnification of 450 times. By using its length-measuring function, the pitch of the lattice-shaped conductive mesh was measured. The measurements were carried out at arbitrary 5 points of one sample having a size of 20 cm × 20 cm, and the average value was defined as a line width and a pitch of the conductive mesh. In this case, the pitch of the conductive mesh was defined as a distance between centers of gravity of a certain opening section of the mesh structure and an adjacent opening section having one side commonly shared with this opening section. In this case, a member, formed by pasting the sample on the sticker layer side onto a glass plate having a thickness of 2.5 mm, was used as the sample.

(6) Measurements of Viscosity

By using a digital rheometer (DV-E) manufactured by Brookfield, measurements were carried out to find a viscosity at 23°C with the spindle being set to LV1. Measurements of ten times were executed on each sample, and the average value was defined as a viscosity of the hard coat layer paint.

(7) Measurements of Refractive Index

A material coating agent of a layer to form a measuring object was applied to a silicon wafer by a spin coater so as to have a dried film thickness of 0.1 $\mu$m. Next, by using an inert oven INH-21CD (manufactured by Koyo Thermo System Co., Ltd.), heating and curing processes were carried out at 130°C for one minute (curing conditions of a low refractive index layer) so that a coat film was obtained. The coat film thus formed was measured to find a refractive index at 633 nm by using a phase-difference measuring device (NPDM-1000, manufactured by Nikon Corporation).

(8) Thickness Measurement of Laminated Layer

A cross section of a sample was observed by a transmission electron microscope (Model H-7100FA, manufactured by Hitachi, Ltd.) at an acceleration voltage of 100 kV. In the case of a filter using a glass substrate, the film separated from glass was evaluated. The sample adjustments were conducted by using an ultrathin section method. The sample was observed in a magnification of 100,000 times so that the thickness of each of the layers was measured.

(9) Luminous Reflectance

By using a spectrophotometer (UV3150PC, manufactured by Shimadzu Corporation), the reflectance (one surface reflection) was calculated within a wavelength range of 380 to 780 nm, with an incident angle of 5 degrees relative to the measuring surface, so that the luminous reflectance (stimulus value Y of reflection specified by JIS Z8701-1999) was found. In order to eliminate influences of reflection from non-measuring surface side of a sample, the sample was prepared by pasting the sticker layer side of the sample to a glass plate of 2. 5 mm in thickness, with a vinyl tape (NO.21, special width, black, thickness: 0.2 mm, manufactured by Nitto Denko Corporation) being pasted to the opposite side of the glass plate so as to prevent bubbles from being mingled therein, and measurements were carried out thereon. The spectral three-dimensional angles were measured by the spectrophotometer so that the reflectance (one-surface light-ray reflectance) was measured in accordance with JIS Z8701-1999. The calculation expression was shown below:

$T = K \cdot \int S(\lambda) \cdot y(\lambda) \cdot R(\lambda) \cdot d\lambda$ (where an integration section is 380 to 780 nm).
T: one surface light ray reflectance
S($\lambda$): Distribution of standard light rays to be used for color display
y($\lambda$): Isochromatic function in XYZ display system
R($\lambda$): Spectral three-dimensional angle reflectance

(10) Luminous Transmittance

By using a spectrophotometer (UV3150PC, manufactured by Shimadzu Corporation), the transmittance (one surface reflection) was calculated within a wavelength range of 300 to 1300 nm, with respect to an incident light from the viewer side (resin layer side) so that the luminous transmittance in a visible light wavelength range (380 to 780 nm) was found. In this case, the luminous transmittance (T) refers to a value by which a ratio ($\Phi t/\Phi i$, stipulated by JIS Z8105 (2000)) between a light ray $\Phi t$ that transmits a filter and a light ray $\Phi i$ that is made incident on an object is represented in percentage, that is, Y of three stimulus values of object colors caused by transmission in the XYZ colorimetric system (stipulated by JIS Z8701-1999). In this case, a member, formed by pasting the sample on the sticker layer side onto a glass plate having a thickness of 2.5 mm, was used as the sample.

(11) Evaluation on Reflection (Front side)

A filter was pasted onto black paper (AC card #300, available from Oji Special Paper Co., Ltd.), with the visible surface side (resin layer side) of a sample facing up (that is, the sticker surface is pasted to black paper). The resultant sample was placed in a dark room, with two 3-wavelength fluorescent lamps (National Palook 3-wavelength type, natural white fluorescent lamp (F. L15EX-N 15W)) being placed 200 cm above the filter sample. The visible surface of the filter was observed with the naked eye, with a distance of 30 cm from the front side so that, with respect to reflection fluorescent lamp images on the filter visible surface, the definition of outlines thereof was evaluated.

- Outlines of the reflection images were unclear : ⊙ (Very good)
- Outlines of the reflection images were slightly clear: O (Good)
- Outlines of the reflection images were virtually clear: Δ (Permissible)
- Outlines of the reflection images were clearly visible: × (Bad)

A single sheet of the filter was evaluated by five persons based upon the respective levels, and the most frequent determination result was adopted. When there were two most frequent determination results, the worse evaluation result was adopted (when the two most frequent determination results were "O" and "Δ", "Δ" was adopted, when they were "Δ" and "×", "×" was adopted, and when they were "O" and "×", "×" was adopted).

(12) Evaluation on Reflection (Diagonal)

A filter was pasted onto black paper (AC card #300, available from Oji Special Paper Co., Ltd.), with the visible surface side (resin layer side) of a sample facing up (the sticker surface is pasted to black paper). The resultant sample was placed in a dark room, with two 3-wavelength fluorescent lamps (National Palook 3-wavelength type, natural white fluorescent lamp (F.L15EX-N 15W)) being placed at a position 200 cm higher than the base on which the filter sample was placed. The visible surface of the filter was observed with the naked eye diagonally with an angle of 45°, with a distance of 30 cm so that, with respect to reflection fluorescent lamp images on the filter visible surface, the definition of outlines thereof was evaluated.

- Outlines of the reflection images were unclear: ⊙ (Very good)
- Outlines of the reflection images were slightly clear: O (Good)
- Outlines of the reflection images were virtually clear: Δ (Permissible)

- Outlines of the reflection images were clearly visible: $\times$ (Bad)

A single sheet of the filter was evaluated by five persons based upon the respective levels, and the most frequent determination result was adopted. When there were two most frequent determination results, the worse evaluation result was adopted (when the two most frequent determination results were "O" and "Δ", "Δ" was adopted, when they were "Δ" and "×", "×" was adopted, and when they were "O" and "×", "×" was adopted).

(13) Evaluation of Luster

A filter was pasted onto black paper (AC card #300, available from Oji Special Paper Co., Ltd.), with the visible surface side (resin layer side) of a sample facing up (that is, the sticker surface is pasted to black paper). The resultant sample was placed in a dark room, with two 3-wavelength fluorescent lamps (National Palook 3-wavelength type, natural white fluorescent lamp (F.L15EX-N 15W)) being placed 200 cm above the filter sample setting base. The visible surface of the filter was observed with the naked eye, with a distance of 30 cm from virtually the front side, so that luster on the peripheral portions of reflection fluorescent lamp images on the filter visible surface thereof was evaluated.

- Surface smoothness was good, with very good luster: ☉ (Very good)
- Surface smoothness was good, with good luster: O (Good)
- Slight roughness was seen on the surface: Δ (Permissible)
- Roughness was clearly seen on the surface: $\times$ (Bad)

A single sheet of the filter was evaluated by five persons based upon the respective levels, and the most frequent determination result was adopted. When there were two most frequent determination results, the worse evaluation result was adopted (when the two most frequent determination results were "O" and "Δ", "Δ" was adopted, when they were "Δ" and "×", "×" was adopted, and when they were "O" and "×", "x" was adopted) .

Example 1

A filter for a display was manufactured under the following conditions.

<Preparation of Conductive Layer>

On one surface of an optical polyester film (Lumirror (registered trademark) U426, available from Toray Industries, Inc., thickness: 100 μm), a nickel layer (thickness: 0.02 μm) was formed by using a vacuum vapor deposition method under vacuum of $3 \times 10^{-3}$ Pa at normal temperature. Moreover, a copper film (thickness: 3 μm) was further formed thereon by using the vacuum vapor deposition method under vacuum of $3 \times 10^{-3}$ Pa at normal temperature in the same manner. Thereafter, on the surface on the copper layer side, a photoresist layer was applied and formed, and the photoresist layer was exposed through a mask having a lattice-shaped mesh pattern, and developed, and this was then subjected to an etching process so that a conductive mesh was manufactured. Moreover, the conductive mesh was subjected to a blackening process (oxidizing process). The conductive mesh had a line width of 12 μm, a pitch of 300 μm, a thickness of 3 μm and an aperture ratio of 87%.

<Preparation of Hard Coat Layer>

A commercially available hard coat agent (Opstar (registered trademark) Z7534: solid component concentration: 60% by mass) was diluted with methyl isobutyl ketone so as to set the solid component concentration to 35% by mass so that a paint for a hard coat layer was prepared. The viscosity of the coating solution was 2 mPa·s. Onto the conductive mesh of the conductive layer obtained as described above, this paint was applied by using a micro gravure coater, and after having been dried for one minute at 80°C, the resultant layer was irradiated with ultraviolet rays at 0.5 J/cm$^2$ to be cured; thus, a hard coat layer was formed. The mass coated amount (after dried and cured) of the hard coat layer was 7 g/m$^2$. Moreover, the refractive index was 1.52.

<Preparation of Reflection Preventing Layer>

The following paint for a low refractive index layer was applied onto the hard coat layer formation surface by using a micro gravure coater. Next, the resultant layer was dried and cured at 130°C for one minute to form a low refractive index layer having a refractive index of 1.36 and a thickness of 90 nm so that a reflection preventing layer was manufactured.

<Preparation of Paint for Low Refractive Index Layer>

Methyltrimethoxy silane (95.2 parts by mass) and trifluoropropyl trimethoxy silane (65.4 parts by mass) were dissolved in propylene glycol monomethyl ether (300 parts by mass) and isopropanol (100 parts by mass). To this solution were added dropwise a dispersion solution of silica fine particles with voids formed inside outer cores thereof, having a number average particle size of 50 nm (isopropanol dispersion type, solid component concentration: 20.5%, available from JGC Catalysts and Chemicals Ltd.)(297.9 pats by mass), water (54 parts by mass) and formic acid (1.8 parts by mass) while being stirred, so as not to allow the reaction temperature to exceed 30°C. After the adding dropwise, the resultant solution was heated for two hours at a bath temperature of 40°C, and the solution was then heated for two hours at a bath temperature of 85°C so that after a heating process for 1.5 hours, with its inside temperature being raised to 80°C, the solution was cooled to room temperature so that a polymer solution was obtained. To the resultant polymer solution was added a mixture formed by dissolving aluminum tris(acetyl acetate)(trade name: Alumi Chelate A(W), available from Kawaken Fine Chemicals Co., Ltd.)(4.8 parts by mass) serving as an aluminum-based curing agent in methanol (125 parts by mass), and to this were further added isopropanol (1500 parts by mass) and propylene glycol monomethyl ether (250partsbymass), and this mixture was stirred for two hours at room temperature so that a low refractive index paint was prepared.

<Preparation of Near Infrared-Ray Blocking Layer with Ne-cutting Function>

KAYASORB (registered trademark) IRG-050, available from Nippon Kayaku Co., Ltd. (14.5 parts by mass), serving as a near infrared-ray absorbing coloring matter, Ex Color (registered trademark) IR-10A, available from Nippon Shokubai Co., Ltd. (8 parts by mass), TAP-2 manufactured by Yamada Chemical Co. , Ltd. (2. 9 parts by mass) serving as an organic coloring matter having a main absorbing peak at 593 nm, and methyl ethyl ketone (2000 parts by mass) were stirred and mixed with one another to be dissolved. This solution, serving as a transparent polymer resin binder solution, was stirred and mixed with HALSHYBRID (registered trademark) IR-G205 available from Nippon Shokubai Co., Ltd. (solution with a solid component concentration of 29%) (2000 parts by mass) so that a paint was prepared. Onto an optical polyester film surface on the side opposite to the side bearing the hard coat layer, the above-mentioned paint was applied by using a die coater, and the resultant layer was dried at 130°C so that a near infrared-ray blocking layer having a thickness of 10 μm was formed.

<Preparation of Color Correcting Layer>

An organic color correcting coloring matter was contained in an acryl-based transparent sticker. The added amount of a coloring matter in each of levels was adjusted so as to set the luminous transmittance of the final filter to 40%. This sticker was laminated on the near infrared-ray blocking layer with a thickness of 25 μm.

Example 2

A filter for a display was manufactured in the same manner as in Example 1 except that the mass coated amount (after dried and cured) of the hard coat layer was set to 10 g/m$^2$.

Example 3

A filter for a display was manufactured in the same manner as in Example 1 except that by using a solution prepared by diluting a commercially available hard coat agent (Opstar (registered trademark) Z7534 available from JSR Corporation; solid component concentration: 60% by mass) with methyl isobutyl ketone so as to set the solid component concentration to 45% by mass (viscosity of the coating solution: 3.5 mPa·s) as a paint for the hard coat layer, the mass coated amount (after dried and cured) of the hard coat layer was set to 13 g/m$^2$.

Comparative Example 1

A filter for a display was manufactured in the same manner as in Example 2 except that no reflection preventing layer was formed.

Comparative Example 2

On an optical polyester film (Lumirror (registered trademark) U426, available from Toray Industries, Inc., thickness: 100 μm), the following hard coat agent used in Example 1 was applied by using a micro gravure coater, and after having been dried for one minute at 80°C, the resultant layer was irradiated with ultraviolet rays at 0.5 J/cm$^2$ so that a hard coat layer was formed. The mass coated amount (after dried and cured) of the hard coat layer was 4.0 g/m$^2$. A commercially available hard coat agent (Opstar (registered trademark) Z7534 available from JSR Corporation: solid component concentration: 60% by mass) was diluted with methyl isobutyl ketone so as to set the solid component concentration to 35% by mass so that a paint for a hard coat layer was prepared. The viscosity of the coating solution was 2 mPa·s. By using the resultant hard coat film, a filter for a display was manufactured in the same manner as in Example 1.

(Evaluation)

With respect to the respective samples prepared as described above, the resin layer occupancy R, depth (D) of the recess of the resin layer, center-line average roughness Ra of the resin layer, luminous reflectance, reflection image and luster were evaluated. The results are shown in Table 1.

[Table 1]

| | Resin layer occupancy R | Luminous reflectance | Conductive mesh | | | | Structure of resin layer | Coating solution viscosity of hard coat layer | Mass coated amount of hard coat layer | Depth D of recess | Center-line average roughness Ra | Reflection image | | Luster |
|---|---|---|---|---|---|---|---|---|---|---|---|---|---|---|
| | | | Thickness (μm) | Pitch (μm) | Aperture ratio (%) | Line width (μm) | HC: Hard coat layer LR: Low refractive index layer | | | | | Front side | 45° | |
| | (%) | (%) | | | | | | (mPa·s) | (g/m2) | (μm) | (nm) | | | |
| Example 1 | 14 | 2.5 | 3 | 300 | 87 | 12 | HC/LR | 2 | 7 | 0.8 | 109 | O | O | ⊙ |
| Example 2 | 8 | 2.5 | 3 | 300 | 87 | 12 | HC/LR | 2 | 10 | 0.4 | 48 | O | Δ | ⊙ |
| Example 3 | 18 | 2.5 | 3 | 300 | 87 | 12 | HC/LR | 3.5 | 13 | 0.3 | 50 | O | O | ⊙ |
| Example 4 | 19 | 2.5 | 3 | 150 | 85 | 10 | HC/LR | 3.5 | 7 | 1.2 | 160 | O | O | ⊙ |
| Example 5 | 7 | 2.5 | 3 | 150 | 85 | 10 | HC/LR | 2 | 13 | 0.3 | 40 | O | Δ | ⊙ |
| Example 6 | 12 | 2.5 | 6 | 300 | 84 | 20 | HC/LR | 2 | 8.5 | 1.2 | 175 | O | O | ⊙ |
| Comparative Example 1 | 10 | 5.2 | 3 | 300 | 87 | 12 | HC | 2 | 10 | 0.4 | 59 | × | Δ | ⊙ |
| Comparative Example 2 | - | 2.3 | None | None | None | None | HC/LR | 2 | 4 | - | 11 | O | × | ⊙ |
| Comparative Example 3 | 2 | 2.5 | 3 | 150 | 85 | 10 | HC/LR | 2 | 17 | 0.1 | 25 | O | × | ⊙ |
| Comparative Example 4 | 35 | 5.1 | 3 | 150 | 85 | 10 | HC | 10 | 7 | 0.6 | 95 | × | ⊙ | O |
| Comparative Example 5 | 13 | 5.1 | 6 | 300 | 84 | 20 | HC | 2 | 8.5 | 2.1 | 290 | × | O | O |
| Comparative Example 6 | 65 | 2.6 | 6 | 300 | 84 | 20 | HC/LR | 8 | 6 | 1.8 | 270 | ⊙ | ⊙ | × |

(continued)

| | Resin layer occupancy R | Luminous reflectance | Conductive mesh | | | | Structure of resin layer | Coating solution viscosity of hard coat layer | Mass coated amount of hard coat layer | Depth D of recess | Center-line average roughness Ra | Reflection image | | Luster |
|---|---|---|---|---|---|---|---|---|---|---|---|---|---|---|
| | (%) | (%) | Thickness ($\mu$m) | Pitch ($\mu$m) | Aperture ratio (%) | Line width ($\mu$m) | HC: Hard coat layer LR: Low refractive index layer | (mPa·s) | (g/m2) | ($\mu$m) | (nm) | Front side | 45° | |
| Comparative Example 7 | 25 | 5.1 | 6 | 300 | 84 | 20 | HC | 4.5 | 10 | 0.9 | 170 | × | ⊙ | O |

EP 2 302 422 A1

Table 1 indicates that Examples of the present invention were superior in reflection preventing characteristics from the front side, reflection preventing characteristics from a diagonal direction and luster. In contrast, since Comparative Example 1 had no reflection preventing layer, the reflection preventing characteristics from the front side were inferior (because of high luminous reflectance). In Comparative Example 2, since a PET film having no recessed structure was used as the base member (having no conductive mesh), the resin layer had no recesses (the resin layer had no recessed structure), with the result that the reflection preventing characteristics from a diagonal direction were inferior.

Example 4

<Preparation of Conductive Layer>

On one surface of an optical polyester film (Lumirror (registered trademark) U426, available from Toray Industries, Inc., thickness: 100 $\mu$m), a nickel layer (thickness: 0.02 $\mu$m) was formed by using a vacuum vapor deposition method under vacuum of $3 \times 10^{-3}$ Pa at normal temperature. Moreover, a copper film (thickness: 3 $\mu$m) was further formed thereon by using the vacuum vapor deposition method under vacuum of $3 \times 10^{-3}$ Pa at normal temperature in the same manner. Thereafter, on the surface on the copper layer side, a photoresist layer was applied and formed, and the photoresist layer was exposed through a mask having a lattice-shaped mesh pattern, and developed, and this was then subjected to an etching process so that a conductive mesh was manufactured. Moreover, the conductive mesh was subjected to a blackening process (oxidizing process). The conductive mesh had a line width of 10 $\mu$m, a pitch of 150 $\mu$m, a thickness of 3 $\mu$m and an aperture ratio of 85%.

<Preparation of Hard Coat Layer>

A commercially available hard coat agent (Opstar (registered trademark) Z7534, available from JSR Corporation: solid component concentration: 60% by mass) was diluted with methyl isobutyl ketone so as to set the solid component concentration to 45% by mass so that a paint for a hard coat layer was prepared. The viscosity of the coating solution was 3.5 mPa·s.
Onto the conductive mesh of the conductive layer obtained as described above, this paint was applied by using a micro gravure coater, and after having been dried for one minute at 80°C, the resultant layer was irradiated with ultraviolet rays at 0.5 J/cm$^2$ to be cured; thus, a hard coat layer was formed. The mass coated amount (after dried and cured) of the hard coat layer was 7 g/m$^2$.

<Preparation of Reflection Preventing Layer>

A low refractive index layer was formed by a coating process in the same manner as in Example 1 on the hard coat layer. A fil.ter for a display was manufactured in the same manner as in Example 1 except for this process.

Example 5

A conductive mesh was manufactured in the same manner as in Example 4. The same paint for a hard coat layer as that of Example 1 was applied onto the conductive mesh so that a hard coat layer having a mass coated amount of 13 g/m$^2$ was formed. A filter for a display was manufactured in the same manner as in Example 4 except for this process.

Comparative Example 3

A conductive mesh was manufactured in the same manner as in Example 4. The same paint for a hard coat layer as that of Example 1 was applied onto the conductive mesh so that a hard coat layer having a mass coated amount of 17 g/m$^2$ was formed. A filter for a display was manufactured in the same manner as in Example 1 except for this process.

Comparative Example 4

A conductive mesh was manufactured in the same manner as in Example 4. Onto the conductive mesh, a commercially available hard coat agent (Opstar (registered trademark) Z7534, available from JSR Corporation: solid-component concentration: 60% by mass) was applied so that a hard coat layer having a mass coated amount of 7 g/m$^2$ was formed. A filter for a display was manufactured in the same manner as in Example 1 except for this process. In this case, no reflection preventing layer was formed on the hard coat layer.

(Evaluation)

With respect to the respective samples prepared as described above, the resin layer occupancy R, depth (D) of the recess of the resin layer, center-line average roughness Ra of the resin layer, luminous reflectance, reflection image and luster were evaluated. The results are shown in Table 1. Table 1 indicates that Examples of the present invention were superior in reflection preventing characteristics from the front side, reflection preventing characteristics from a diagonal direction and luster. In contrast, since Comparative Example 3 had a small resin layer occupancy R, the reflection preventing characteristics from a diagonal direction were inferior. Since Comparative Example 4 had no reflection preventing layer, the reflection preventing characteristics from the front side were inferior (because of high luminous reflectance). Moreover, since Comparative Example 4 has a high resin occupancy R, there was slight degradation of luster.

[Example 6]

<Preparation of Conductive Layer>

On one surface of an optical polyester film (Lumirror (registered trademark) U36, available from Toray Industries, Inc., thickness: 125 $\mu$m), a lattice-shaped mesh pattern was gravure-printedbyusing a catalyst inkmade of a paste containing palladium colloid, and this film was immersed in an electroless copper plating solution so that an electroless copper plating process was carried out thereon, and this was successively subjected to an electrolytic copper plating process, and then subjected to an electrolytic plating process of an Ni-Sn alloy so that a conductive mesh was manufactured. The conductive mesh had a line width of 20 $\mu$m, a pitch of 300 $\mu$m, a thickness of 6 $\mu$m and an aperture ratio of 84%.

<Preparation of Hard Coat Layer>

A commercially available hard coat agent (Opstar (registered trademark) Z7534, available from JSR Corporation: solid component concentration: 60% by mass) was diluted with methyl isobutyl ketone so as to set the solid component concentration to 35% by mass so that a paint for a hard coat layer was prepared. The viscosity of the coating solution was 2 mPa·s. Onto the conductive mesh of the conductive layer obtained as described above, this paint was applied by using a micro gravure coater, and after having been dried for one minute at 80°C, the resultant layer was irradiated with ultraviolet rays at 0.5 J/cm$^2$ to be cured; thus, a hard coat layer was formed. The mass coated amount (after dried and cured) of the hard coat layer was 8.5 g/m$^2$.

<Preparation of Reflection Preventing Layer>

A low refractive index layer was formed by a coating process in the same manner as in Example 1 on the hard coat layer. A filter for a display was manufactured in the same manner as in Example 1 except for this process.

Comparative Example 5

A conductive mesh was manufactured in the same manner as in Example 6. The same paint for a hard coat layer as that of Example 6 was applied onto the conductive mesh so that a hard coat layer having a mass coated amount of 8.5 g/m$^2$ was formed. No reflection preventing layer was laminated thereon. A filter for a display was manufactured in the same manner as in Example 6 except for this process.

Comparative Example 6

A conductive mesh was manufactured in the same manner as in Example 6. Onto the conductive mesh, a solution obtained by diluting a commercially available hard coat agent (Opstar (registered trademark) Z7534 available from JSR Corporation; solid component concentration: 60% by mass) with methyl isobutyl ketone so as to set the solid component concentration to 56% by mass (viscosity of the coating solution: 8 mPa·s) was applied so as to set the mass coated amount of the hard coat layer to 6 g/m$^2$. A filter for a display was manufactured in the same manner as in Example 6 except for this process.

Comparative Example 7

A conductive mesh was manufactured in the same manner as in Example 6. A paint for a hard coat layer as described below was applied onto the conductive mesh so that a hard coat layer having a mass coated amount of 10 g/m$^2$ was formed. A filter for a display was manufactured in the same manner as in Example 6 except for this process. In this case, no reflection preventing layer was formed on the hard coat layer.

<Preparation of Hard Coat Paint>

A coating solution containing dipentaerythritol hexaacrylate (40 parts by weight), N-vinyl pyrrolidone (8 parts by mass), methyl methacrylate (2 parts by mass) and methyl ethyl ketone (50 parts by mass) was prepared. The viscosity of the coating solution was 4.5 mPa·s.

(Evaluation)

With respect to the respective samples prepared as described above, the resin layer occupancy R, depth (D) of the recess of the resin layer, center-line average roughness Ra of, the resin layer, luminous reflectance, reflection image and luster were evaluated. The results are shown in Table 1. Table 1 indicates that Examples of the present invention were superior in reflection preventing characteristics from the front side, reflection preventing characteristics from a diagonal direction and luster. In contrast, since Comparative Example 5 had no reflection preventing layer, the luminous reflectance was too high, with the result that the reflection preventing characteristics from the front side were inferior. Moreover, since Comparative Example 6 had a very high resin occupancy R, on the contrary, there was degradation of luster. Since Comparative Example 7 had no reflection preventing layer, the luminous reflectance was too high, with the result that the reflection preventing characteristics from the front side were inferior. Moreover, since Comparative Example 7 had a very high resin occupancy R, there was slight degradation of luster.

INDUSTRIAL APPLICABILITY

The present invention is applied to a filter for a display to be attached to a screen of a display device such as a CRT, an organic EL display, a liquid crystal display and a plasma display. In particular, the present invention is desirably applicable to a filter for a display to be attached to the screen of the plasma display.

EXPLANATION OF REFERENCE NUMERALS

| | |
|---|---|
| 1 | Transparent base member |
| 2 | Conductive mesh |
| 3 | Resin layer |
| 4 | Hard coat layer |
| 5 | Reflection preventing layer |
| 6a | Perpendicular passing through center of gravity G1 |
| 6b | Perpendicular passing through center of gravity G2 |
| 7 | Opening section |
| 8 | Center of gravity of opening section |
| 9 | Top |
| 10 | Bottom |
| 11 | Bottom |
| D | Depth of recess of resin layer |
| α | Area of triangle surrounded by points ABC |
| β | Cross-sectional area of resin layer |

**Claims**

**1.**  A filter for a display comprising:

a conductive layer composed of a conductive mesh formed on a transparent base member;
a resin layer including at least a hard coat layer and a reflection preventing layer, which is formed on the conductive layer, with the conductive layer, the hard coat layer and the reflection preventing layer being stacked thereon in this order,

wherein there is a recess on the resin layer at a portion (opening section) where no conductive mesh exists, with a resin layer occupancy R, defined below, being in a range from 5% or more but less than 20%:

$$R = (\beta/\alpha) \times 100$$

$\alpha$: area of triangle ABC
$\beta$: area of resin layer located within triangle ABC where with respect to the respective apexes A, B and C of the triangle ABC, when the cross section of the resin layer is viewed in a direction orthogonal to the transparent base member so as to pass through two centers of gravity (G1, G2) of adjacent opening sections, surrounded by the conductive mesh, in a surface direction of the transparent base member, a top of the resin layer on the conductive mesh located between the centers of gravity G1 and G2 is defined as C, an intersection between a perpendicular (perpendicular relative to the transparent base member) passing through one of the two centers of gravity G1 and the surface of the resin layer is defined as A, and an intersection between a perpendicular (perpendicular relative to the transparent base member) passing through the other center of gravity G2 and the surface of the resin layer is defined as B.

2. The filter for a display according to claim 1, wherein the depth D of the recess of the resin layer is in a range from 0.1 to 5 $\mu$m.

3. The filter for a display according to claim 1 or 2, wherein the conductive mesh has a thickness in a range from 0.5 to 8 $\mu$m, and the conductive mesh also has a pitch in a range from 50 to 500 $\mu$m.

4. The filter for a display according to any one of claims 1 to 3, wherein the reflection preventing layer is composed of only a low refractive index layer having a refractive index in a range from 1.23 to 1.42.

5. The filter for a display according to any one of claims 1 to 4, further comprising:

a functional layer having at least one function selected from the group consisting of a near infrared-ray blocking function, a color-tone correcting function, an ultraviolet-ray blocking function and a Ne-cutting function.

Fig. 1

EP 2 302 422 A1

Fig. 2

EP 2 302 422 A1

Fig. 3

EP 2 302 422 A1

Fig. 4

EP 2 302 422 A1

Fig. 5

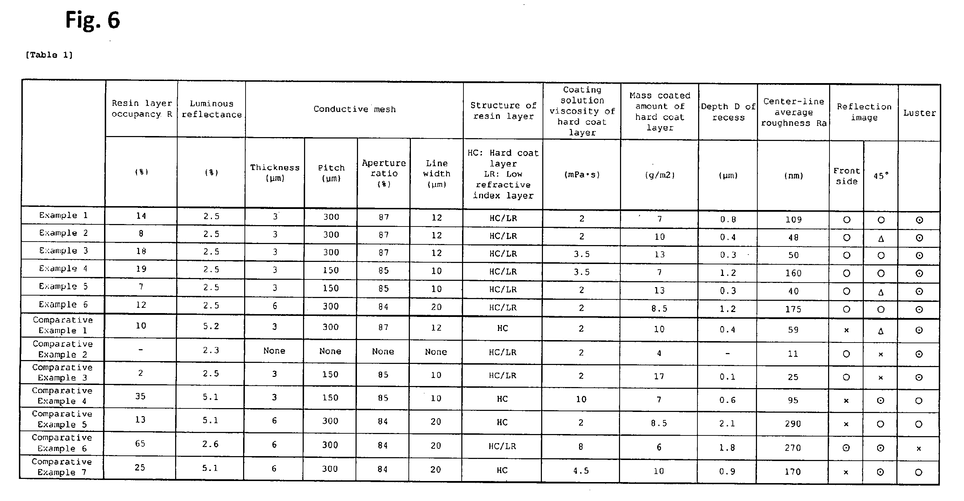

## Fig. 6

[Table 1]

| | Resin layer occupancy R (%) | Luminous reflectance (%) | Conductive mesh | | | | Structure of resin layer HC: Hard coat layer LR: Low refractive index layer | Coating solution viscosity of hard coat layer (mPa·s) | Mass coated amount of hard coat layer (g/m2) | Depth D of recess (μm) | Center-line average roughness Ra (nm) | Reflection image | | Luster |
| | | | Thickness (μm) | Pitch (μm) | Aperture ratio (%) | Line width (μm) | | | | | | Front side | 45° | |
| Example 1 | 14 | 2.5 | 3 | 300 | 87 | 12 | HC/LR | 2 | 7 | 0.8 | 109 | O | O | ⊙ |
| Example 2 | 8 | 2.5 | 3 | 300 | 87 | 12 | HC/LR | 2 | 10 | 0.4 | 48 | O | Δ | ⊙ |
| Example 3 | 18 | 2.5 | 3 | 300 | 87 | 12 | HC/LR | 3.5 | 13 | 0.3 | 50 | O | O | ⊙ |
| Example 4 | 19 | 2.5 | 3 | 150 | 85 | 10 | HC/LR | 3.5 | 7 | 1.2 | 160 | O | O | ⊙ |
| Example 5 | 7 | 2.5 | 3 | 150 | 85 | 10 | HC/LR | 2 | 13 | 0.3 | 40 | O | Δ | ⊙ |
| Example 6 | 12 | 2.5 | 6 | 300 | 84 | 20 | HC/LR | 2 | 8.5 | 1.2 | 175 | O | O | ⊙ |
| Comparative Example 1 | 10 | 5.2 | 3 | 300 | 87 | 12 | HC | 2 | 10 | 0.4 | 59 | × | Δ | ⊙ |
| Comparative Example 2 | – | 2.3 | None | None | None | None | HC/LR | 2 | 4 | – | 11 | O | × | ⊙ |
| Comparative Example 3 | 2 | 2.5 | 3 | 150 | 85 | 10 | HC/LR | 2 | 17 | 0.1 | 25 | O | × | ⊙ |
| Comparative Example 4 | 35 | 5.1 | 3 | 150 | 85 | 10 | HC | 10 | 7 | 0.6 | 95 | × | ⊙ | O |
| Comparative Example 5 | 13 | 5.1 | 6 | 300 | 84 | 20 | HC | 2 | 8.5 | 2.1 | 290 | × | O | O |
| Comparative Example 6 | 65 | 2.6 | 6 | 300 | 84 | 20 | HC/LR | 8 | 6 | 1.8 | 270 | ⊙ | ⊙ | × |
| Comparative Example 7 | 25 | 5.1 | 6 | 300 | 84 | 20 | HC | 4.5 | 10 | 0.9 | 170 | × | ⊙ | O |

| INTERNATIONAL SEARCH REPORT | International application No. |
|---|---|
| | PCT/JP2009/062180 |

A. CLASSIFICATION OF SUBJECT MATTER
*G02B5/02*(2006.01)i, *G02B1/10*(2006.01)i, *G02B1/11*(2006.01)i, *G09F9/00*
(2006.01)i, *H05K9/00*(2006.01)i

According to International Patent Classification (IPC) or to both national classification and IPC

B. FIELDS SEARCHED

Minimum documentation searched (classification system followed by classification symbols)
G02B5/02, G02B1/10, G02B1/11, G09F9/00, H05K9/00

Documentation searched other than minimum documentation to the extent that such documents are included in the fields searched
Jitsuyo Shinan Koho        1922-1996   Jitsuyo Shinan Toroku Koho   1996-2009
Kokai Jitsuyo Shinan Koho   1971-2009   Toroku Jitsuyo Shinan Koho   1994-2009

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| P,X | JP 2008-216770 A (Bridgestone Corp.), 18 September, 2008 (18.09.08), Full text; all drawings (Family: none) | 1-5 |
| A | JP 2005-301191 A (Dainippon Printing Co., Ltd.), 27 October, 2005 (27.10.05), Full text; all drawings & US 2005/0163958 A1   & KR 10-2005-0046545 A & CN 001616995 A | 1-5 |
| A | JP 2005-84476 A (Dainippon Printing Co., Ltd.), 31 March, 2005 (31.03.05), Full text; all drawings (Family: none) | 1-5 |

☒ Further documents are listed in the continuation of Box C.    ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered   to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 30 July, 2009 (30.07.09) | 11 August, 2009 (11.08.09) |

| Name and mailing address of the ISA/ | Authorized officer |
|---|---|
| Japanese Patent Office | |
| Facsimile No. | Telephone No. |

Form PCT/ISA/210 (second sheet) (April 2007)

**EP 2 302 422 A1**

| INTERNATIONAL SEARCH REPORT | International application No. |
|---|---|
| | PCT/JP2009/062180 |

C (Continuation). DOCUMENTS CONSIDERED TO BE RELEVANT

| Category* | Citation of document, with indication, where appropriate, of the relevant passages | Relevant to claim No. |
|---|---|---|
| A | JP 2003-75604 A (Nitto Denko Corp.), 12 March, 2003 (12.03.03), Par. Nos. [0017] to [0025], [0035]; Fig. 1 (Family: none) | 1-5 |
| A | JP 2006-293334 A (Fuji Photo Film Co., Ltd.), 26 October, 2006 (26.10.06), Par. No. [0013]; Fig. 1(a) (Family: none) | 1-5 |

Form PCT/ISA/210 (continuation of second sheet) (April 2007)

42

**EP 2 302 422 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005316450 A
- JP 2006195305 A
- JP 2007096049 A
- JP 2006054377 A
- JP 2006210572 A
- JP 2007140282 A
- JP 2007243158 A
- WO 200407810 A
- JP 2004221564 A
- JP 2006012935 A